(19) Europäisches Patentamt
European Patent Office
Office européen des brevets

(11) **EP 2 011 588 B1**

(12) **EUROPEAN PATENT SPECIFICATION**

(45) Date of publication and mention
of the grant of the patent:
**16.11.2016 Bulletin 2016/46**

(51) Int Cl.:
**B22D 11/115** *(2006.01)*        **B22D 11/11** *(2006.01)*

(21) Application number: **07742788.8**

(86) International application number:
**PCT/JP2007/059353**

(22) Date of filing: **24.04.2007**

(87) International publication number:
**WO 2007/126114 (08.11.2007 Gazette 2007/45)**

(54) **CASTING METHOD**

**GIESSVERFAHREN**

**PROCEDE DE COULAGE**

(84) Designated Contracting States:
**DE FR GB**

(30) Priority: **25.04.2006 PCT/JP2006/309133**

(43) Date of publication of application:
**07.01.2009 Bulletin 2009/02**

(73) Proprietor: **Ebis Corporation
Sagamihara-shi,
Kanagawa 228-0825 (JP)**

(72) Inventor: **EBISU, Yoshio
Sagamihara-shi, Kanagawa 228-0825 (JP)**

(74) Representative: **Henkel, Breuer & Partner
Patentanwälte
Maximiliansplatz 21
80333 München (DE)**

(56) References cited:
JP-A- 05 208 245      JP-A- 57 184 572
JP-A- 62 227 569      US-A- 3 842 895
US-A- 4 540 038       US-A- 5 222 545

- **AMBARDAR R ET AL: "Effect of steady magnetic field on the structure of unidirectionally solidified metal alloy castings", TRANSACTIONS OF THE INDIAN INSTITUTE OF METALS, INDIAN INSTITUTE OF METALS, CALCUTTA, IN, vol. 40, no. 1, 1 February 1987 (1987-02-01), pages 22-26, XP009165974, ISSN: 0019-493X**
- **B.Q.Li: "Solidification Processing of Materials in Magnetic Fields", JOM, vol. 50, no. 2 February 1998 (1998-02), Retrieved from the Internet: URL:http://www.tms.org/pubs/journals/JOM/9 802/Li/Li-9802.html [retrieved on 2015-01-20]**
- **NEUBRAND A C ET AL: "Segregation during horizontal Bridgman growth under an axial magnetic field", JOURNAL OF CRYSTAL GROWTH, ELSEVIER, AMSTERDAM, NL, vol. 181, no. 1-2, 1 October 1997 (1997-10-01), pages 133-144, XP004115978, ISSN: 0022-0248, DOI: 10.1016/S0022-0248(97)00275-3**
- **RIAHI D N ED - AKIMOTO KATSUHIRO SUEMASU TAKASHI OKUMURA HAJIME: "Effects of a vertical magnetic field on chimney convection in a mushy layer", JOURNAL OF CRYSTAL GROWTH, ELSEVIER, AMSTERDAM, NL, vol. 216, no. 1-4, 1 June 2000 (2000-06-01), pages 501-511, XP004206276, ISSN: 0022-0248, DOI: 10.1016/S0022-0248(00)00371-7**
- **YESILYURT S ET AL: "A numerical investigation of the effect of thermoelectromagnetic convection (TEMC) on the Bridgman growth of Ge1-xSix", JOURNAL OF CRYSTAL GROWTH, ELSEVIER, AMSTERDAM, NL, vol. 207, no. 4, 15 December 1999 (1999-12-15), pages 278-291, XP004363816, ISSN: 0022-0248, DOI: 10.1016/S0022-0248(99)00377-2**

**Description**

Technical Field

This invention is concerned with the casting technologies for primarily improving macrosegregation defects in unidirectionally solidified castings which possess columnar dendrite structure consisting of polycrystalline grains (so called DS material) or dendrite structure consisting of a single crystalline grain (so called Monocrystal or SX material).

Background Art

A. Unidirectionally Solidified Castings

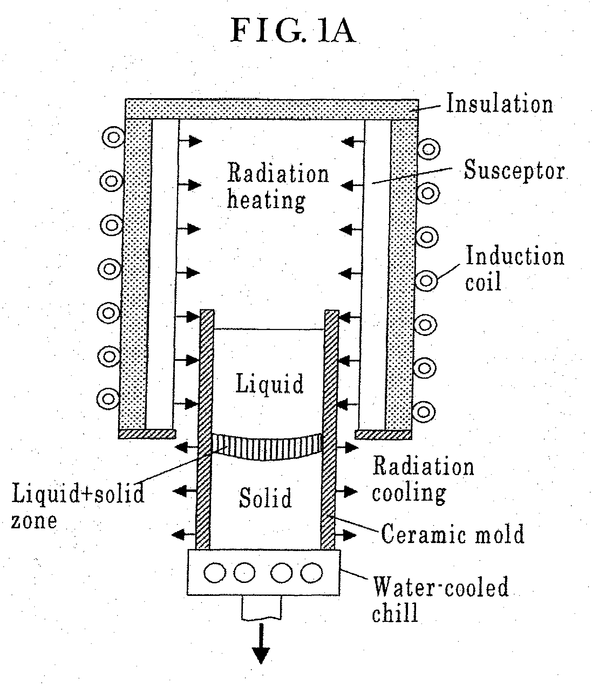

Typical examples of unidirectionally solidified castings in the technical field of this invention are turbine blades used in aircraft jet engines, power plant gas turbines, and so on. FIG. 1(A) shows schematic diagram of a typical directional solidification apparatus in use of today. After pouring molten metal into the ceramic mold cavity (of complicated 3D shape) placed on a water-cooled copper chill, the mold is withdrawn in gravitational direction out of the radiation heating zone, thereby allowing directional solidification to obtain polycrystalline columnar dendrite structure (termed DS material) or single crystal dendrite structure (termed SX material).

In the figure shown are the liquid, the liquid-solid coexisting (mushy) and the solid phases during withdrawal (the details of casting chamber, vacuum chamber and so on are omitted). Because the turbine blades are used under severe conditions, Ni-base superalloys with excellent thermal resistances such as high temperature strength are used as a major material. However casting defects such as channel segregation (so called freckles), misoriented grains, microporosity tend to occur in these blades, thus lowering the yield of the products (for example, refer to p.321 of Ref. (1)).

Presently, the mechanism of the formation of freckles has qualitatively been considered as follows:

One of the main features of Ni-base superalloys is that they possess $\gamma'$ phase (intermetallic compound called gamma prime whose basic composition is $Ni_3$ (Al, Ti) which precipitates coherently with $\gamma$ matrix. And generally speaking, the higher the volume fraction of $\gamma'$, the higher the high temperature strength.

However, as solidification proceeds in an alloy containing such elements as Al, Ti and W lighter than Ni, the interdendritic liquid density is decreased with increased solute concentrations of these lighter elements. Therefore, when solidifying such alloy in the direction opposite to gravitational direction, the liquid density at the bottom of mushy zone, i.e., at the roots of dendrites becomes relatively smaller compared to that at the liquid-mushy phase boundary, i.e., at dendrites tips. Such alloy is called "solutally unstable" against convection in this description. On the other hand, the temperature at the roots of dendrites is lower than that at dendrite tips, and therefore it does not give rise to convective flow due to density difference: Thus 'thermally stable'.

If the solutal instability is larger than the thermal stability, inversed density profile forms, and the liquid phase in the mushy zone indices upward flow due to this density difference, thus leading to the formation of channel segregation (or so called freckles). Also, dendritic growth tends to break down and misoriented grains are likely to form. This kind of alloy is called 'upward type of buoyancy' in this description. It has been understood that the freckles formed in Ni-base superalloy blades are caused by the above-mentioned upward flow due to liquid density difference within the mushy zone.

Despite that a vast amount of efforts have been paid to improve these casting defects by optimizing casting parameters such as sustaining temperature in the radiation heating zone, withdrawal rate, radiation cooling rate, etc. or by adjusting alloy compositions so as to add heavier elements than Ni (for example Ta), it still remains insufficient. Thus, a novel technology to eliminate the above-mentioned defects is highly wanted at present.

B. Ingot Making by the Use of Remelting Processes The remelting processes for ingot making such as ESR and VAR are characterized by relatively shallow shapes of melt pool and mushy zones. In the above-mentioned unidirectional solidification, the solidification from the side wall of mold is retarded. On the other hand, these remelting processes differ in the point that the solidification proceeds from the side wall of mold as well (usually water-cooled copper mold is used). It is well known that the freckles (channel segregation) and other macrosegregations take place in Mi-base superalloy ingots produced by ESR and VAR (for example, refer to Ref. (2)), and that these macrosegregation defects can occur in the alloys of 'downward type of buoyancy' where interdendritic liquid density increases as solidification proceeds, as well as in the aforementioned alloys of 'upward type' of buoyancy.

In order to reduce these defects, various attempts have been being undertaken ranging from regulating cooling conditions so as to form as shallow a melt pool depth as possible (especially useful for downward type alloys of buoyancy) to increasing cooling rate, to setting proper melting rate, or to adjusting chemical compositions. However, as the cross-section of the ingots become larger, the formation of these macrosegregation defects is unavoidable. Thus, an innovative technology is strongly desired capable of constantly producing large cross-section ingots with less macrosegregation which are used in Ni-base superalloy turbine disks, Fe-base alloy turbine rotors for power plant and so on.

JP 62 227569A relates to a process of obtaining a directionally solidified columnar grain structure but not to control macrosegregation. For this purpose a static magnetic field of the order of 0.1 Tesla is applied to suppress the convection in front of a directionally solidifying interface.

JP 57 184572A relates to a process to reduce the scattering of grain orientations of a directionally solidified casting. To accomplish this, the document teaches to exert a static magnetic field as low as 0.1 Tesla onto a melt pool.

US 4540038A relates to a process to produce a DS or SX grain structure in an airfoil section of a directionally solidified turbine blade and a fine grained structure (nondirectional solidified) in a root section of the blade. To accomplish this, a sufficiently slow rate to allow directional solidification is utilized for the airfoil section, and when the solidification reaches the interface between the airfoil section and the root section, electromagnetic stirring is commenced in order to eliminate the inhomogeneous zone adjacent to the just-solidified portion.

B.Q.Li: "Solidification Processing of Materials in Magnetic Fields", JOM, vol.50, no.2 February 1998 (1998-02) is concerned with the technology utilizing magnetic fields to control convection in a melt liquid zone. The document describes that electromagnetic braking helps to reduce macrosegregation by reducing the chance of bringing broken dendrites that are rich in alloy element into the melting pool and then settling in the center of the ingot, and the document describes that magnetic damping is solely devoted to the control of the convection within the semiconductor melting pool.

Riahi D.N.: "Effects of a vertical magnetic field on chimney convection in a mushy layer", Journal of Crystal Growth, vol. 216, No. 1-4 1 June 2000, pages 501-511, discloses a method for the solidification of alloys under an externally imposed magnetic field in the vertical direction and the paper specifically investigates non-linear compositional convection in cylindrical chimneys within a mushy layer and the effect of the magnetic field on the freckles.

Disclosure of Invention

The invention provides a unidirectional solidification process with the features of claim 1. This invention is concerned with unidirectional solidification process and provides with casting technologies for producing high quality castings and ingots without such macrosegregation defects as freckles caused primarily by the liquid flow within the mushy zone during solidification. With special attention paid to the above-mentioned liquid flow phenomena within the mushy zone, this invention has clarified for the first time that the interdendritic fluid flow with extremely low velocity can be suppressed by exerting high magnetic field onto the whole mushy zone, and thereby the formation of the macrosegregation defects such as freckles can be eliminated.

Brief Description of Drawings

FIG. 1 shows the schematic diagrams of unidirectional solidification process applied to Specific Example 1: (A) shows a conventional method and (B) the schematic by this invention.

FIG. 2 shows the relationships between temperature and volume fraction solid during solidification of Ni-10 wt%Al and IN718 alloys (with respect to IN718, refer to FIG. 1 of Ref. (10)).

FIG. 3 shows the variation of Al solute composition in liquid during the solidification of Ni-10 wt%Al alloy.

FIG. 4 shows the variations of solute compositions in liquid during the solidification of IN718 alloy (refer to FIG. 2 of Ref. (1)).

FIG. 5 shows the variations of liquid densities during the solidifications of Ni-10 wt%Al and IN718 alloys.

FIG. 6 is the contours of Al concentrations showing the effects of magnetic field densities Bz exerted in the axial direction on the freckle segregates of unidirectionally solidified round ingots of Ni-10 wt%Al alloy. (A) Bz=0, (B) Bz=5 Tesla, (C) Bz=10 Tesla, and (D) the effect of Bz at RR' cross section (91.9 mm from the bottom).

FIG. 7 shows the contours of the vol. fraction solid during solidification (after 18 minutes) of the same ingot as that of FIG. 6(A). (A) shows the whole section and (B) the magnified section at O.D.

FIG. 8 shows the fluid flow patterns during solidification (after 18 minutes) of the same ingot as that of FIG. 6. (A) is of Bz=0 and (B) of Bz=10 Tesla.

FIG. 9 is the contours of Al concentrations showing the freckle segregates of unidirectionally solidified Ni-10 wt%Al square ingot of Specific Example 2. (A) shows the freckles at the cross section XX' (86.6 mm from the bottom) and (B) the freckles in the vertical section at the end of Y dir.

FIG. 10 shows (A) the contours of Al concentration (freckle segregates) and vol. fraction solid, and (B) the liquid flow pattern in liquid and mushy zones and the contours of vol. fraction solid (after 20 minutes, at the end of Y dir. of the same ingot as that of

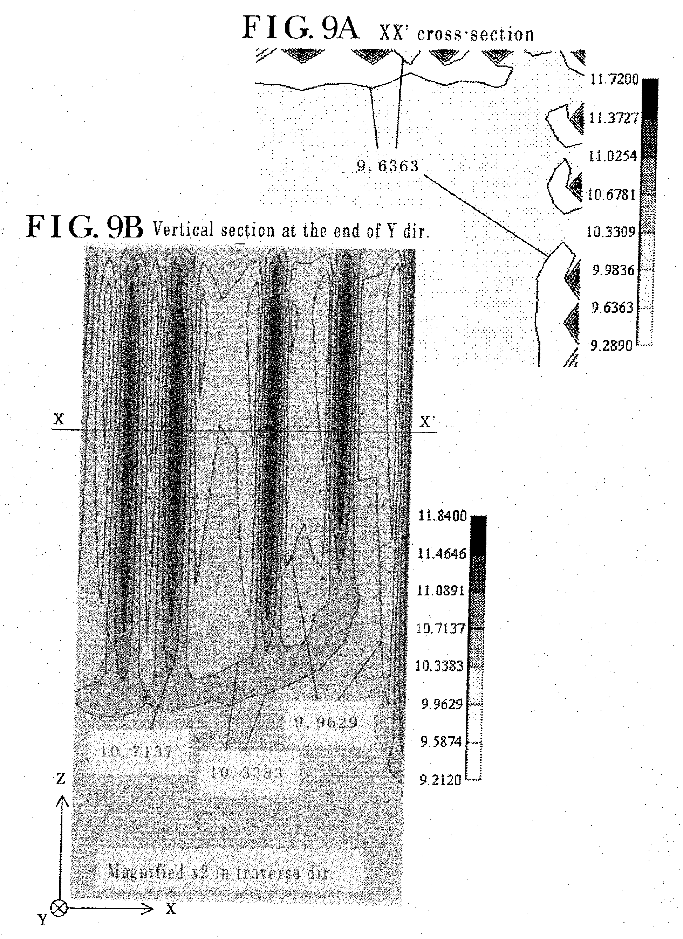

FIG. 9). The contours in the figure denote the fraction solid of 0.2, 0.4, 0.6 and 0.8 respectively. The gray zone in the upper part of background indicates the liquid zone, the light gray zone in the middle the mushy zone and the dark gray zone at the bottom the solid. The velocity vectors are normalized.

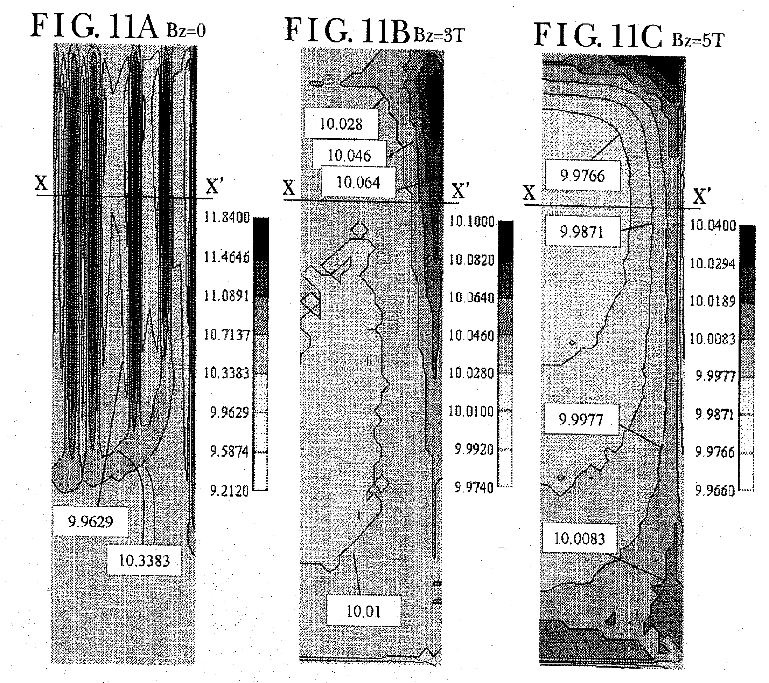

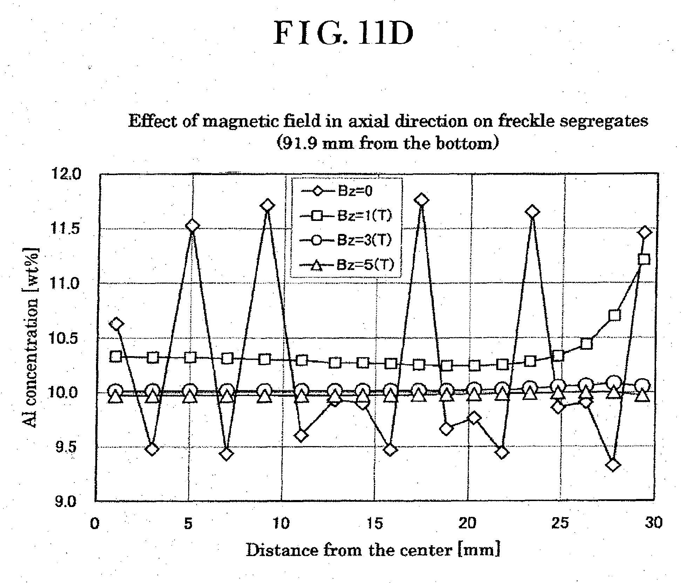

FIG. 11 is the contours of Al concentration showing the effects of magnetic field Bz exerted in the axial direction on the freckle segregates of unidirectionally solidified Ni-10 wt%Al square ingots of the Specific Example 2. (A) is of Bz=0, (B) of Bz=3 Tesla, (C) of Bz=5 Tesla; and (D) shows the suppressing effects of macrosegregations at XX' cross section 91.9 mm from the bottom at the end of Y dir.

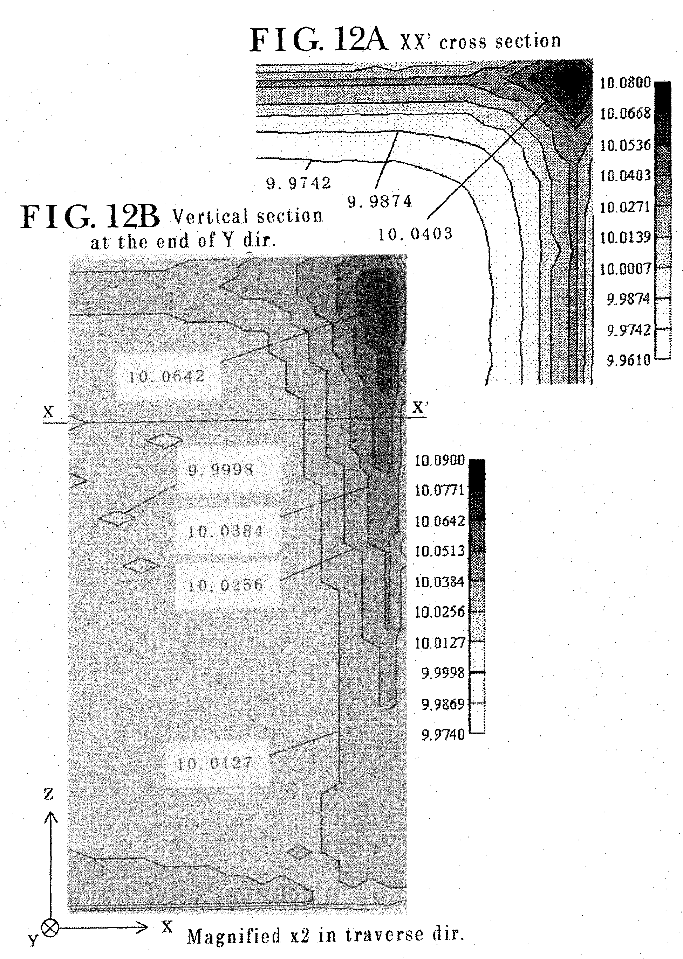

FIG. 12 is the contours of Al concentration showing the effects of magnetic field (By=3 Tesla) exerted in Y direction on the freckle segregates of unidirectionally solidified Ni-10 wt%Al square ingot of the Specific Example 2. (A) shows the segregation at XX' cross section 91.9 mm from the bottom and (B) that at the vertical section at the end of Y direction.

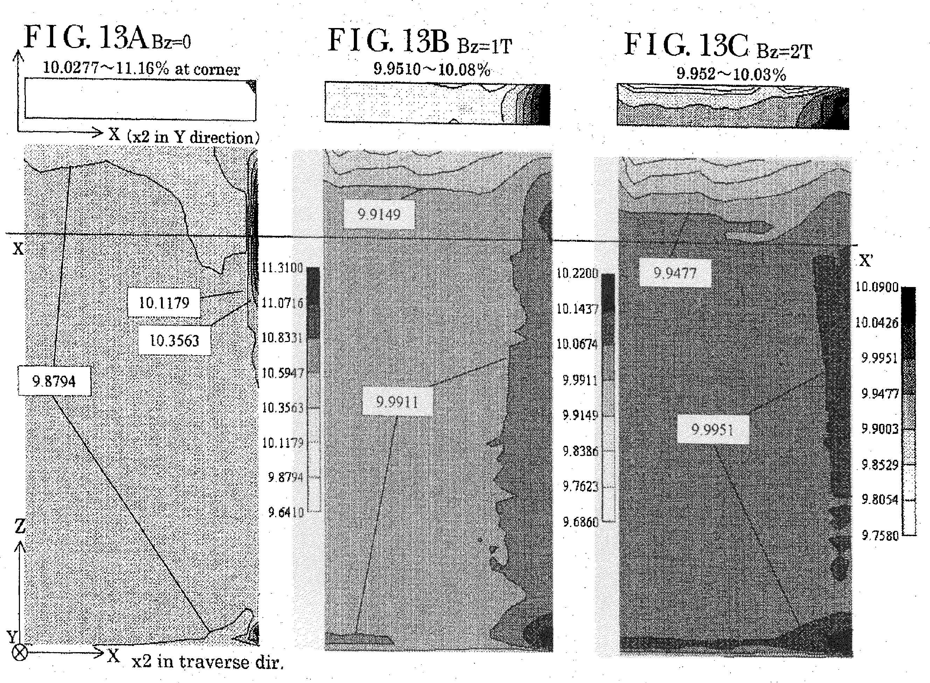

FIG. 13 is the contours of Al concentration showing the effects of magnetic fields Bz in the vertical direction on the freckle segregates of unidirectionally solidified Ni-10 wt%Al thin plate ingots of the Specific Example 3. (A) is of Bz=0, (B) of Bz=1 Tesla and (C) of Bz=2 Tesla. All vertical sections are at the ends of Y dirs., and all cross sections XX' are at 91.9 mm from the bottom.

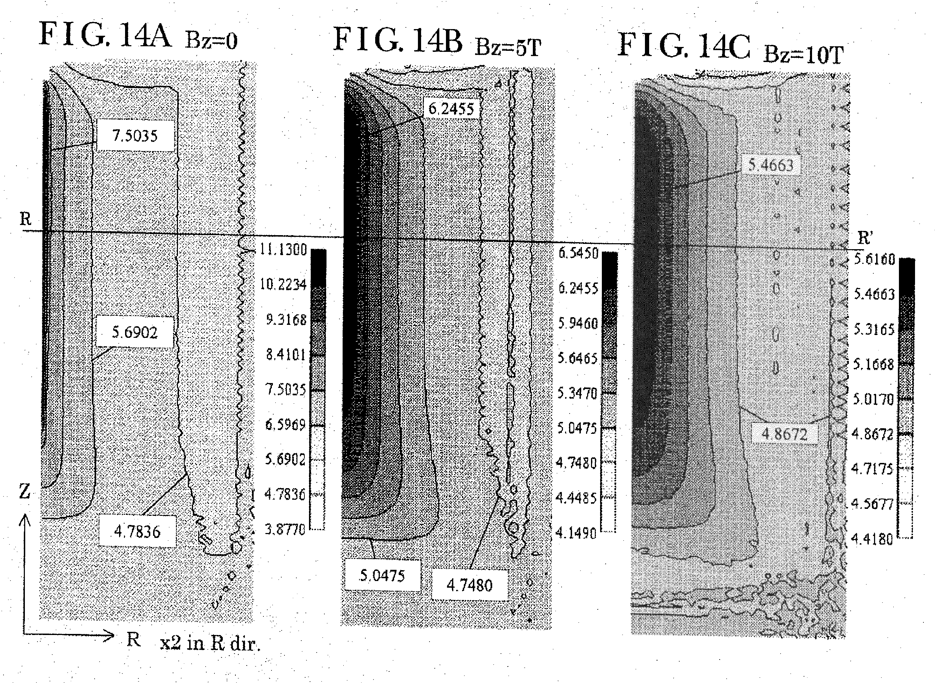

FIG. 14 is the contours of Nb concentration showing the effects of magnetic field Bz in the axial direction on the freckles segregates at the center of remelting-processed IN718 ingots of Specific Example 4. (A) is of Bz=0, (B) of Bz=5 Tesla and (C) of Bz=10 Tesla.

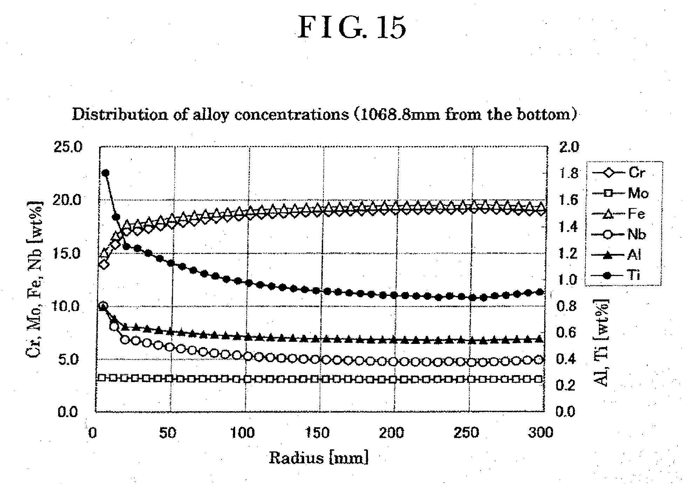

FIG. 15 shows the macrosegregations of each element at RR' cross-section 1068.8 mm from the bottom which corresponds to the case with no magnetic field of FIG. 14.

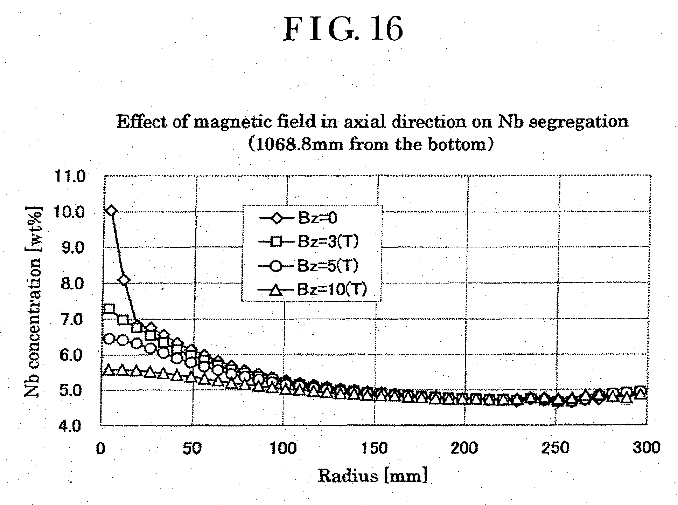

FIG. 16 shows the suppressing effects on the macrosegragation of Nb at RR' cross-section of FIG. 14 (1068.8 mm from the bottom).

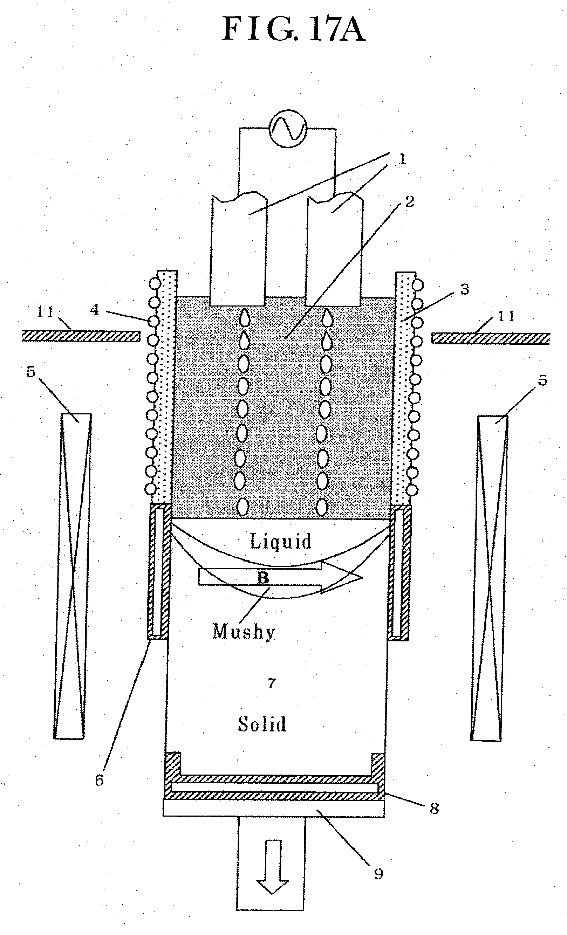

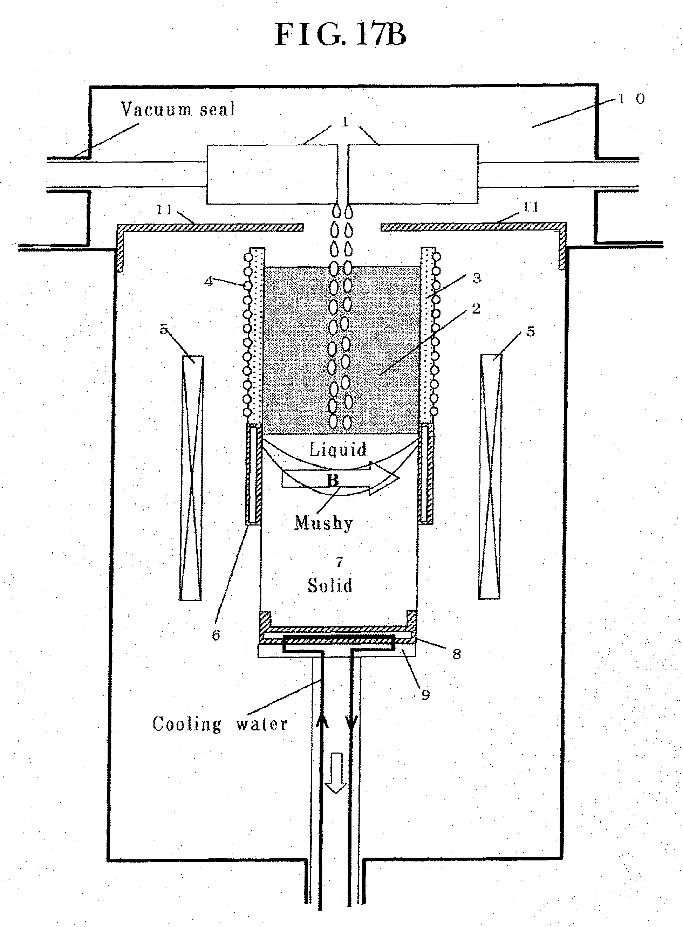

FIG. 17 shows schematic examples of this technology applied to remelting processes. (A) is an example applied to ESR and (B) a combined example of VAR + slag refining + magnetic field.

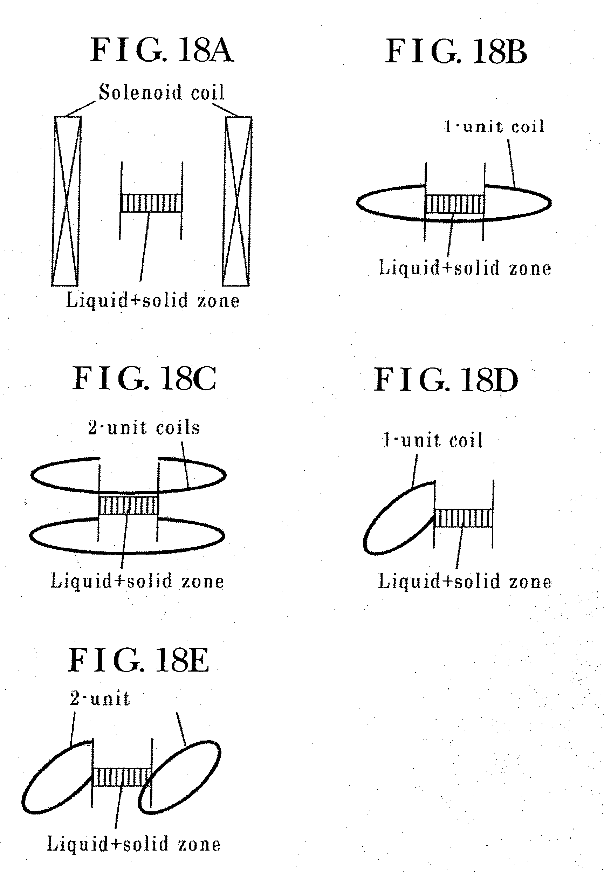

FIG. 18 shows schematic examples of DC coil 5 configurations of this invention. (A) is solenoid coil, (B) 1-unit coil and (C) 2-unit coils (Helmholtz-type or as such). (D) is a race track type 1 unit-coil with the magnetic field exerted in the direction so as to cross the direction of gravity and (E) race track type 2 unit-coils.

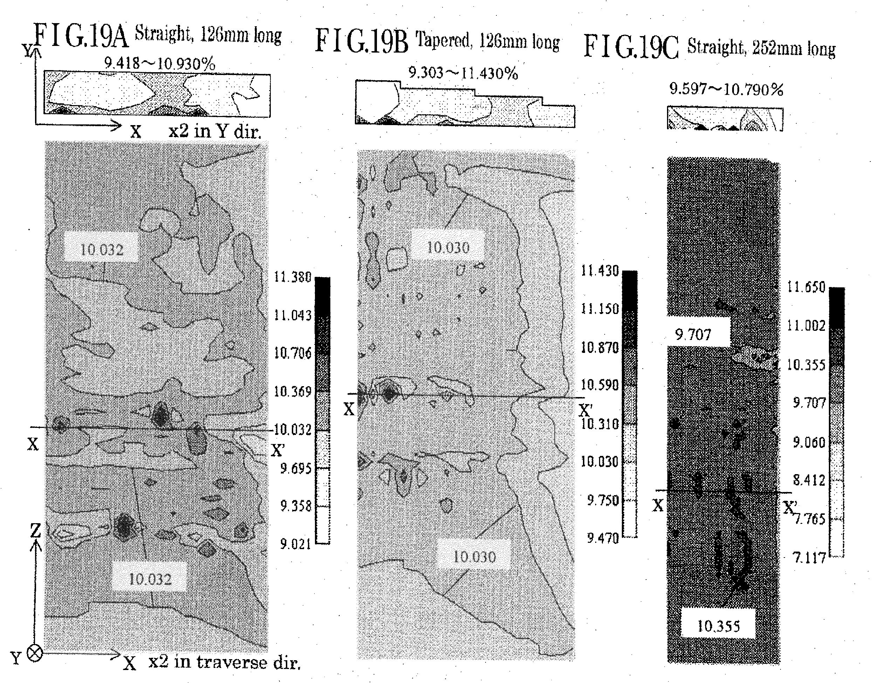

FIG. 19 shows the distributions of Al concentration with no magnetic field for unidirectionally solidified Ni-10 wt%Al thin plate ingots of the Specific Example 3. (A) is of straight, 126 mm long; (B) of tapered, 126 mm long and (C) of straight, 252 mm long.

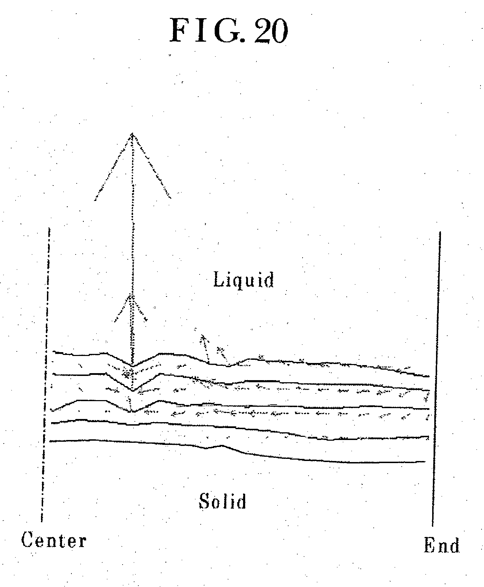

FIG. 20 shows liquid flow vectors within the mushy zone after 1005 seconds from the start of withdrawal (45 mm withdrawn from the bottom) of the tapered ingot of FIG. 19. The contours denote the vol. fractions solid of 0.2, 0.4, 0.6, 0.8 and 1.0 respectively.

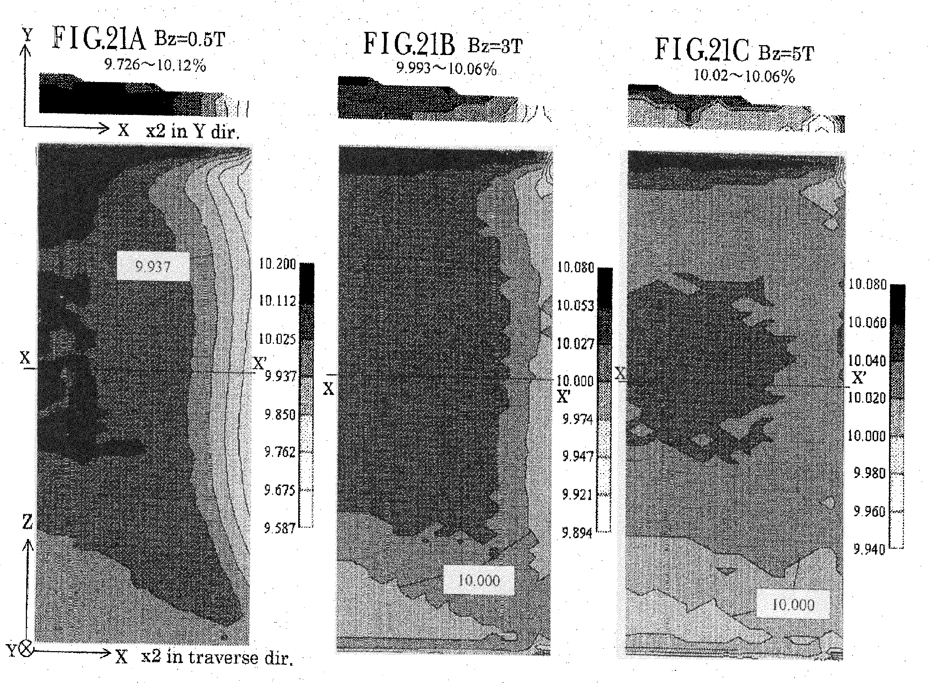

FIG. 21 shows the suppressing effects on macrosegregation when the magnetic field is exerted in the vertical direction for the unidirectional solidification of tapered thin plate ingot of

FIG. 19(B). (A) is of Bz=0.5 Tesla, (B) of Bz=3 Tesla and (C) of Bz=5 Tesla respectively. The cross-sectional diagrams are the distributions at the position XX'.

Explanation of Reference Symbols

1. Electrodes (Consumable electrode)
2. Slag melt
3. Adiabatic refractory sleeve
4. Heater
5. DC coil for exerting static magnetic field in axial or traverse direction
6. Water-cooled mold
7. Ingot
8. Water-cooled bottom plate
9. Platform
10. Vacuum or inert gas atmosphere
11. Magnetic shield

A. Mechanism for the Formation of Macrosegregation

It is well known that various types of macrosegregation including freckles are caused by the interdendritic liquid flow within the mushy zone during solidification. The driving forces for this fluid flow are contraction on solidification, difference in interdendritic liquid density, external force such as electromagnetic force, etc: Among them the convective flow (not exactly convection) due to the difference in the liquid density is particularly important in this invention. It depends on alloy compositions whether the alloy exhibits upward type or downward type or the mixture of these two types of buoyancy (the mixture type is such that the liquid density first decreases as solidification proceeds and then increases again or vice versa), and macrosegregation takes place inherent to the casting process.

B. Suppressing Effects of Fluid Flow by the Application of Magnetic Field

The principles of suppressing effects of fluid flow by the use of static magnetic field is briefly described as follows.

Talking vector notation from the Ohm's law of Magnetohydrodynamics,

$$J = \sigma(E + v \times B) \quad \dots\dots\dots\dots (1).$$

Where, $\sigma$ is electric conductivity of molten metal (1/$\Omega$m), v is flow velocity vector of molten metal (m/s), B is externally applied magnetic flux density vector (Tesla), E is induced electric field strength vector (V/m) and J is induced electric current density vector (A/m$^2$).

From the continuity of electric current field,

$$\nabla \cdot J = 0 \quad \dots\dots\dots\dots (2).$$

Denoting $\phi$ (V) as electric potential,

$$E = -\nabla\phi \quad \dots\dots\dots\dots (3).$$

Then, the electromagnetic force vector (Lorentz force) f (N/m3) is given by the outer product of J and B as

$$f = J \times B \quad \dots\dots\dots\dots (4).$$

These are well known equations.

Substituting Eqs.(1) and (3) into Eq.(2), Eq.(5) is obtained.

$$\nabla \cdot (\sigma \nabla \phi) = \nabla \cdot \sigma (v \times B) \quad \dots\dots\dots\dots (5)$$

Solving Eq.(5) with respect to $\phi$, obtaining J from Eqs.(1) and (3), and then the Lorentz force, i.e., electromagnetic braking force vector f can be calculated from Eq.(4). However, v needs to be calculated from the numerical analysis including momentum equation to be described afterward. The liquid flow field and the electromagnetic field are highly interacted or coupled with each other.

C. Method of Solidification Analysis

The outline of the simulation system for solidification (system name CPRO) will be described bellow which was developed by this inventor to analyze solidification phenomena. The physical variables for describing solidification phenomena are defined by temperature, compositions of alloy elements redistributed in the liquid and solid phases during solidification (take n for the number of elements), liquidus temperature of the relationship between temperature and volume fraction solid, and liquid flow velocity (3 vector components) and pressure of liquid in the bulk liquid and mushy zones. These are called the physical variables in macroscopic scale in this description.

The governing equations corresponding to these n+6 variables are shown in Table 1.

**Table 1 Relationship between physical variables and governing equations (n is the number of alloys)**

| Physical variables | Governing equations |
| --- | --- |
| Temperature | Energy eq. |
| Solute concentrations in | Solute redistribution eqs. of n alloys |

(continued)

| Physical variables | Governing equations |
|---|---|
| liquid<br>Liquidus temperature<br>Liquid flow vectors<br>Pressure of liquid | (Solute mass conservation law)<br>Temperature vs vol. fraction solid eq. of multi-alloy system<br>Momentum eqs. (Darcy's law included)<br>Pressure eq. |
| Number of variables is n+6 | Number of equations is n+6 |

It is known that the fluid flow in the mushy zone is described by Darcy's law, Eq.(6) (refer to p.234 of Ref. (3)). The Darcy's flow is included as one of the resisting force terms in the momentum equations of Table 1.

$$\mathbf{v} = \frac{K}{\mu g_L}(-\nabla P + \mathbf{X}) \quad \ldots\ldots\ldots\ldots\ldots\ldots (6)$$

In Eq.(6), the vector V denotes the interdendritic flow velocity, $\mu$ the viscosity of liquid, $g_L$ the volume fraction liquid, K the permeability, P the pressure of liquid phase, X the body force vector such as gravity and centrifugal force. Furthermore, note that X includes the electromagnetic baking force introduced in this invention as well. K is determined by dendrite morphology and given by Kozney-Calman equation (Ref. (4)) as

$$K = \frac{(1 - gs)^3}{f S_b^2} \quad \ldots\ldots\ldots\ldots\ldots\ldots (7)$$

where, Sb is the surface area of dendrite crystals per unit volume (i.e. specific surface area), and the dimensionless number f has been found to have the value of 5 by the fluid flow experiment using porous media. The permeability K is obtained by the morphological analysis during dendrite growth in microscopic scale: Considering that solidification is one of diffusion-controlled processes in liquid and solid phases, and assuming that dendrite crystals are modeled to consist of cylindrical branches and trunks, and half-sphere tips, Sb can be obtained by solving the diffusion equations of solute elements in the liquid and solid phases. In doing so, no anisotropy of K by dendritic orientation is assumed.

Since the above macroscopic variables are interacted with each other, and moreover deeply coupled with the microscopic dendrite growth, the iterative convergence method was employed to obtain the solution. The details of this numerical method have been described in this inventor's patents (refer to Ref. (5)). In addition, the influences of the above-mentioned electromagnetic braking force by magnetic field have been incorporated into the numerical method. Thus, it has become possible to completely analyze the solidification phenomena with the effects of the electromagnetic braking force taken into account. Here, it has been assumed that the solid phase, i.e., the dendrite network within the mushy zone does not move.

Best Mode for Carrying Out the Invention

A. Specific Example 1: Macrosegregation in Unidirectional Solidification of Ni-10 wt%Al Round Ingot

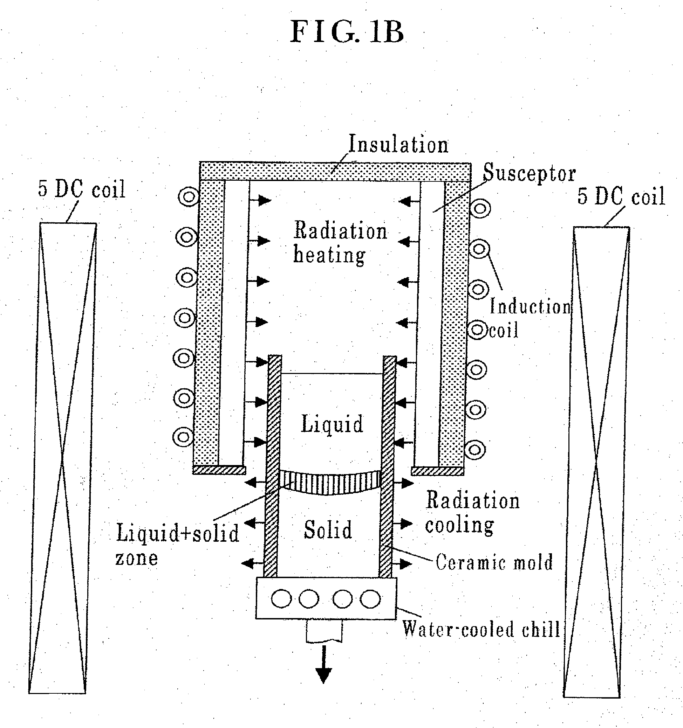

Schematic diagram of a conventional unidirectional solidification apparatus is shown in FIG. 1(A). Susceptor is heated by induction coil and the ceramic mold is then radiation-heated by the susceptor. The bottom of the ceramic mold is cooled by water-cooled chill, and the mold is withdrawn gradually downward to establish unidirectional solidification (instead, it is also possible to rise the heating furnace while the mold is fixed). Giamei and Kear have shown that the channel segregation generally termed 'freckles' appears at O.D. of unidirectionally solidified Ni-base superalloy monocrystal round ingots of the type upward buoyancy (refer to FIGS. 1 to 4 of Ref. (6)), and clarified the size effect that more freckles form as the diameters of the ingots increase (refer to Table II of the same reference). They have also shown that the freckles take place at O.D. of unidirectionally solidified Ni-10 wt%Al single crystal ingot of 1 inch (38.1 mm) diam with the same upward type of buoyancy. In reference to these published data, the ingot configurations and the casting conditions used for the numerical simulations were set as shown in Table 2. The chemical compositions and the physical properties used in the calculations are shown in Table 3. Furthermore, the correction factor $\alpha$ of Sb (specific surface area of dendrite) was adjusted to be 0.4 so that the freckles appear at the O.D. of the ingot in the light of the same Ref (6).

Table 2 Casting parameters

| Unidirectional solidification of round, square and thin plate Ni-10Al ingots | Round ingot solidification of IN718 alloy via remelting process |
|---|---|
| Dimensions of ingots: <br> Round, 68 diam x 126 high (mm) <br> Square, 60 sq x 126 high (mm) (Both ingots with equivalent section areas) <br> Thin plate, 6 thick x 60 wide x 126 high (mm) <br> Dimensions of mold: <br> Ceramic mold thickness 5mm <br> Thickness of bottom plate 1.75mm (Thermal properties of the bottom plate are <br> same as those of ingot) Casting temp: 1420°C (super heat = 20°C) <br><br> Withdrawal rate: 5mm/min <br> Heat flux in radiation heating region: <br> $q = \varepsilon\sigma(T^4 - Tm^4)$ [cal/cm2sec] <br> $\varepsilon$ (emissivity) = 0.05 <br> $\varepsilon$ (emissivity) for thin plate = 0.005 | Dimensions of ingots: <br> Round, 600 diam x 1500 high (mm) <br> Dimensions of mold: <br> Fictitious mold thickness = 20mm <br> Fictitious bottom plate thickness = 37mm <br> (Thermal properties are all same as those of ingot) <br> Initial temp. of the fictitious mold = 1242°C <br><br> Initial temp. of the fictitious bottom plate = 1242°C <br> Casting temp: 1344°C (super heat = 100°C) <br><br> Melting rate: 800 [Kg/hr] <br> Heat flux from the mold OD: <br> $q = h(T - T0)$ [cal/cm2sec] |
| o (Stefan-Boltzmann constant) <br> T (temperature of susceptor) = 1693K <br> Tm (surface temperature of ceramic mold, K) <br> Heat flux in radiation cooling region: <br> $q = \varepsilon\sigma(Tm^4 - T0^4)$ [cal/cm2sec] <br> $\varepsilon$ (emissivity) = 0.10 <br> $\varepsilon$ (emissivity) for thin plate = 0.01 <br> Tm (surface temperature of ceramic mold, K) <br> T0 (room temperature) = 293K <br> Heat flux from the bottom plate: <br> q = h (T-T0) [cal/cm2sec] <br> h (heat transfer coefficient) = 0.002 [cal/cm2sec°C] <br> Preheating temp. of the bottom plate = 1350°C <br> Preheating temp. of the ceramic mold = 1420°C | h (heat transfer coefficient) = 0.01 [cal/cm2sec°C] <br> T (outside temperature of mold) <br> T0 (room temperature) = 293K <br> Heat flux from the bottom plate of ingot: $q = h(T - T0)$ [cal/cm2sec] <br> h (heat transfer coefficient) = 0.05 [cal/cm2sec°C] <br> T (outside temperature of the bottom plate) |
| No heat flow from the melt surface | No heat flow from the melt surface |

Table 3 Chemical compositions and physical properties of Ni-10Al and IN718 alloys

| | | | Cr | Mo | Al | Ti | Fe | Nb |
|---|---|---|---|---|---|---|---|---|
| Ni-10Al (wt%) | | | -- | -- | 10.0 | -- | -- | -- |
| IN718 (wt%) | | | 19.0 | 3.05 | 0.55 | 0.90 | 19.40 | 4.85 |

Liquidus and solidus curves of Ni-Al phase diagram are non-linear as below:

| | | | | | | | |
|---|---|---|---|---|---|---|---|
| Temperature (°C) | 1453 | 1430 | 1420 | 1405 | 1385 | | |
| Liquid composition (wt%) | 0 | 5.15 | 7.2 | 10.05 | 12.9 | | |
| Solid composition (wt%) | 0 | 4.17 | 5.85 | 8.2 | 10.9 | | |

Constants in liquid density equation

$$\rho_L = \rho_{\cdot 0}^L + \sum_n h_n \dot{C}_n^L + \dot{h}^0 T_L :$$

The values of these constants are determined from the densities for pure liquid metals or Ref. (7).

| Alloy | $\rho\ 0^L$ (g/cm$^3$) | $h_0$ (g/cm$^3$°C) | $h_n$ (g/cm$^3$·wt%) | | | | | |
|---|---|---|---|---|---|---|---|---|
| | | | Cr | Mo | Al | Ti | Fe | Nb |
| Ni-10Al | 9.380 | -1.05x10$^{-3}$ | -- | -- | -0.0871 | -- | -- | -- |
| IN718 | 9.453 | -1.022x10$^{-3}$ | -0.0145 | 0.0242 | -0.0953 | -0.0587 | -0.0089 | 0.0029 |

Physical properties of specific surface area of dendrite, Sb (refer to Eq.(28) of Ref. (5)):
Configuration factor of dendrite: $\phi$ =0.67 for cylinder
Surface energy at solid-liquid interface, $\sigma$LS(cal/cm$^2$):
6 x 10$^{-6}$ for Ni-10Al; 5 x 10$^{-5}$ for IN718                           -
Correction factor $\alpha$ of Sb: 0.6 for IN718; 0.4 for Ni-10Al

| | | Ni-10Al | IN718 | | | | | |
|---|---|---|---|---|---|---|---|---|
| Diffusion coefficients in liquid $D^L$ (cm$^2$/s) | | Al | Cr | Mo | Al | Ti | Fe | Nb |
| | | 1.0x10$^{-4}$ | Assumed to be 2.3x10$^{-5}$ for all elements in reference to the data given by Ref. (8) | | | | | |

| | Ni-10Al | IN718 | Bottom plate (dummy): | Shell mold: |
|---|---|---|---|---|
| Specific heat of liquid (cal/g°C) | 0.15 | 0.15(*) | | Specific heat=0.20 |
| Specific heat of solid ($_{JJ}$) | 0.15 | 0.15(*) | Specific | |
| Thermal conductivity (cal/cms°C): | | | heat=0.15 | Thermal conductivity=0.001 |
|   Liquid | 0.064 | 0.064(*) | Thermal conductivity=0.064 | |
|   Solid | 0.064 | 0.064(*) | | |
| Solid density in mushy zone (g/cm$^3$) | 7.4 | 7.94 | | Density=1.7 |
| Density of solid ($_{JJ}$) | 7.4 | 7.95 | Density=7.4 | |

(continued)

| Diffusion coefficients in liquid $D^L$ (cm$^2$/s) | Ni-10Al | IN718 | | | | | |
|---|---|---|---|---|---|---|---|
| | Al | Cr | Mo | Al | Ti | Fe | Nb |
| | $1.0 \times 10^{-4}$ | Assumed to be $2.3 \times 10^{-5}$ for all elements in reference to the data given by Ref. (8) | | | | | |
| Latent heat of fusion (cal/g) | | 50.0 | 50.0 | | | | |
| Viscosity of liquid (poise) | | 0.05 | 0.07(*) | | | | |
| Surface tension of liquid (dyn) | | 920.0 | 920.0(*) | | | | |
| Electric conductivity of liquid in mushy zone (1/$\Omega$cm) | | $10^4$ | $10^4$ | | | | |

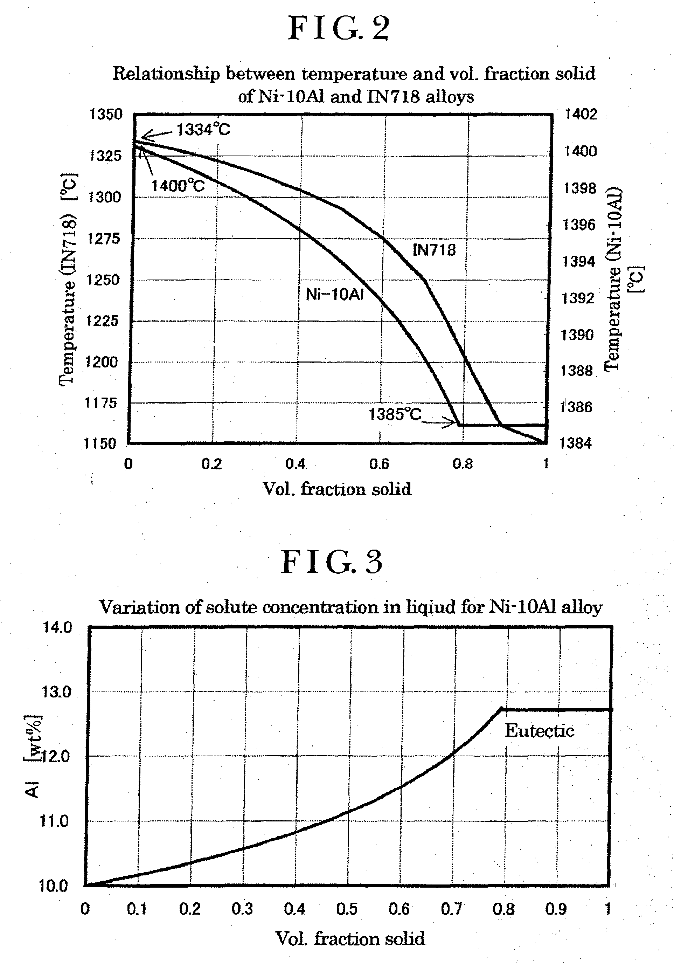

Assuming non-equilibrium solidification (i.e. no solid diffusion, complete liquid diffusion), the relationship between temperature and vol. fraction solid calculated for Ni-10 wt%Al alloy is shown in FIG. 2. This alloy exhibits eutectic at 1385°C. Since Al solutes are rejected into liquid phase from liquid-solid interface with the progress of solidification, the interdendritic Al composition in the liquid phase increases as shown in FIG. 3.

in general, expressing interdendritic liquid density as a function of alloy compositions in the liquid $C_1^L$, $C2^L$, .. and temperature T (refer to $\rho_L$ equation of Table 3), $\rho_L$ is given by

$$\rho_L = \rho_L(C_1^L, C_2^L, \cdots, T) \qquad \ldots\ldots\ldots\ldots\ldots\ldots\ldots\ldots (8).$$

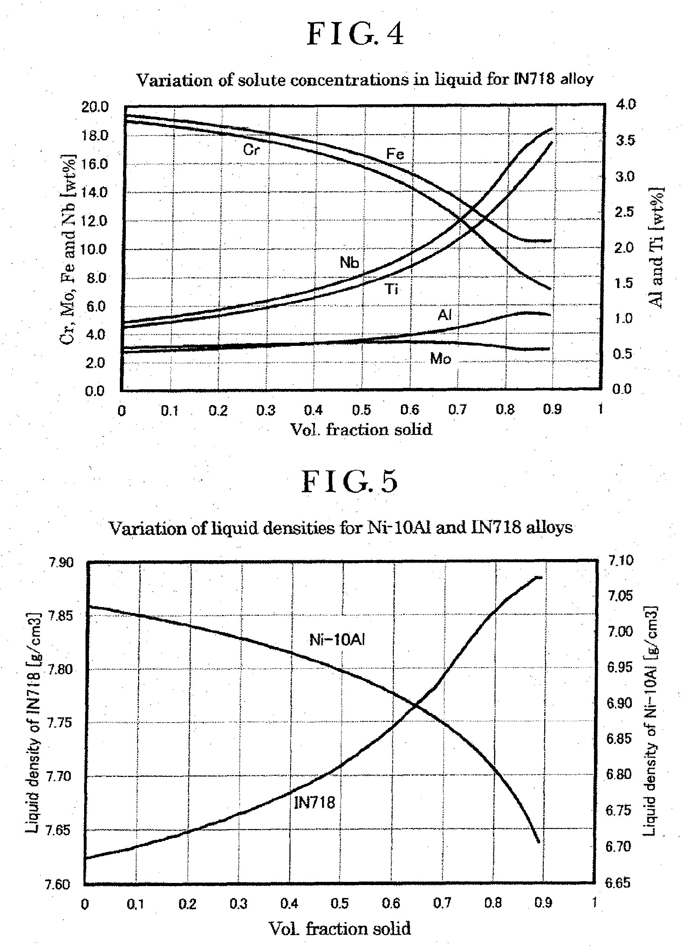

The result of $\rho_L$ by Eq.(8) calculated for Ni-10 wt%Al is shown in FIG. 5, indicating that the alloy is of upward type of buoyancy.

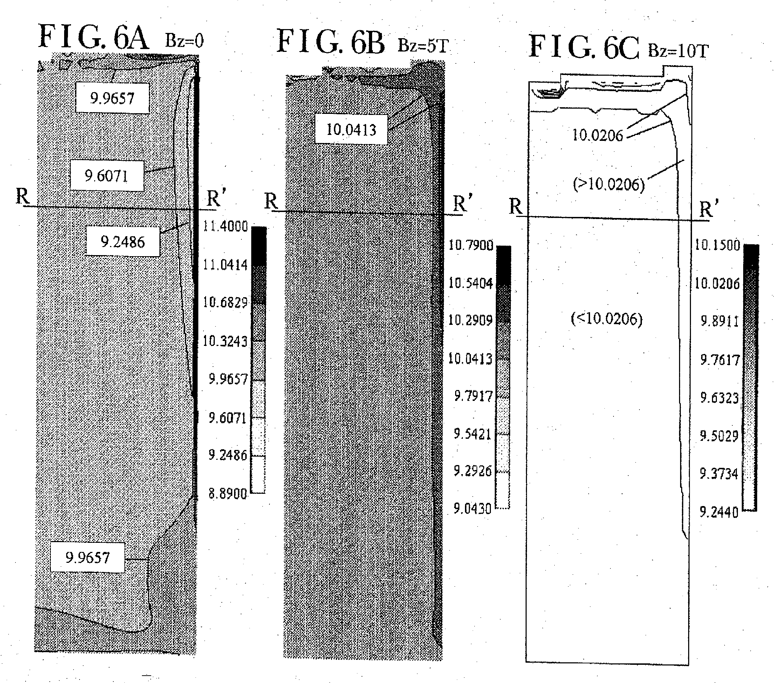

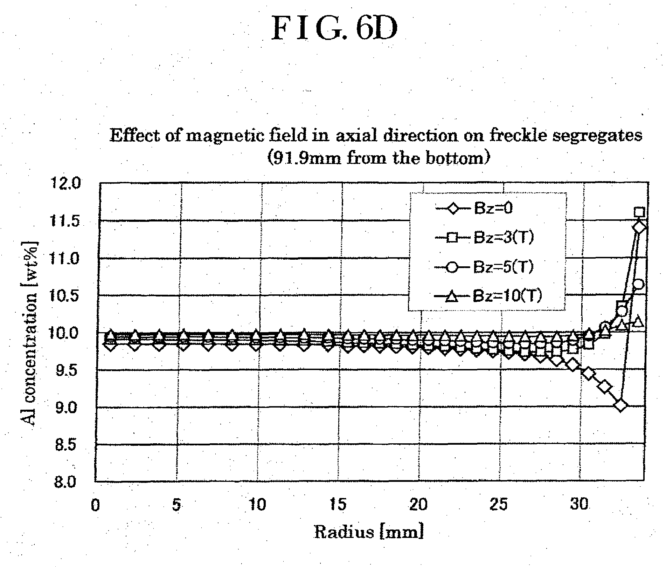

The partition number of elements for the ingot is 2059 (29 in radial dir. x 71 in axial dir.). The computational results are shown in FIGS. 6 to 8. FIGS. 6(A) to 6(C) show the contours of macrosegregation distributions, and FIG. 6(D) the distributions in the radial direction at the position RR' (91.9 mm from the bottom). In the conventional ingot with no magnetic field exerted, the freckles were formed at O.D. as shown FIG. 6(A). Here, the degree of macrosegregation is defined by C/Co (C is calculated solute concentration and Co initial composition (wt%)): C/Co>1 denotes positive segregation and C/Co<1 negative segregation (Co=10 wt%). The maximum value of C/Co is 1.14 of positive segregation at the freckled O.D. Also the lowering of Al concentration (depleted zone) is seen at the adjacent of the freckle (FIG. 6(D)). From these figures there is no suppressing effect on the macrosegregation under Bz=3 Tesla. The macrosegregation was reduced to about one half at Bz=5 Tesla with the maximum value of C/Co=1.08 and practically eliminated at Bz=10 Tesla with the maximum value of C/Co=1.015.

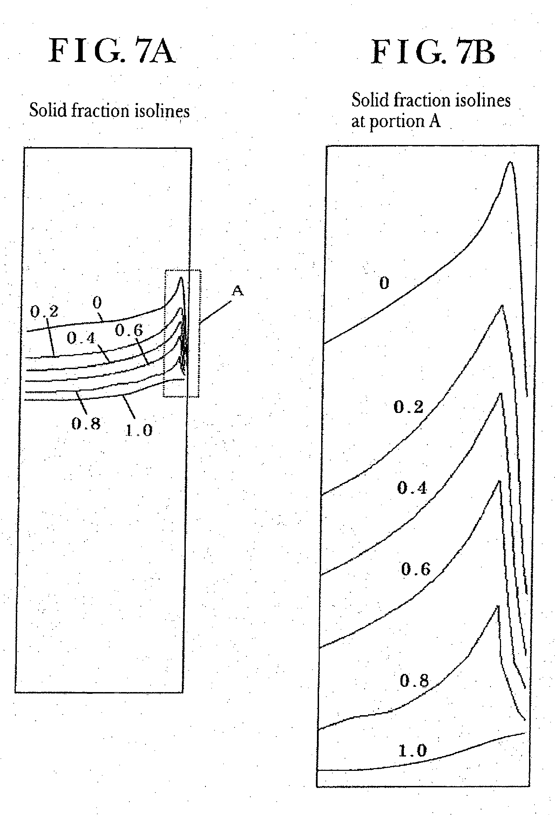

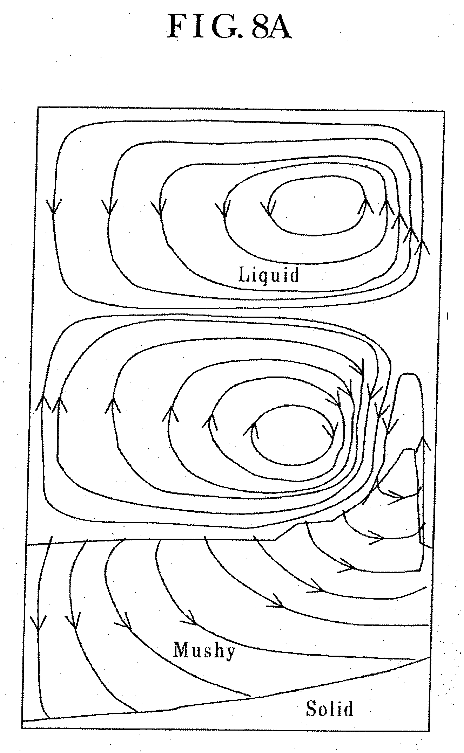

The freckles of the above-mentioned ingot with no magnetic field exerted are caused by the fluid flow pattern within the mushy zone. FIG. 8(A) shows the flow pattern in the bulk liquid and the mushy zone after 18 minutes (solidification time is 29.2 minutes), indicating that the profile of the mushy zone is influenced by the heat extraction from the outside. The fluid flow pattern in the mushy zone is such that as a whole the liquid flows from the center toward the O.D. under the influence of 'upward buoyancy' due to lower liquid density at higher vol. fraction solid region (the bottom side). Thus, at the O.D., the flow occurs from low temperature, high solute concentration liquid of the bottom side to higher temperature, lower solute concentration liquid of the upper side. As a result, the solidification is delayed at the O.D. (if not necessarily leading to remelting), and the liquid becomes easier to flow through (i.e. the permeability K of Eq.(7) becomes larger). Thus, the channel flow path of liquid is developed resulting in the lower vol. fraction solid at the O.D. than that at the I.D. as shown in FIG. 7. [The mechanism of channel segregation has been written more in detail in the aforementioned Ref. (3), p.249.] In such a channel segregates, unidirectional dendrite structure breaks down to form equiaxed dendrites, which accompany porosities due to solidification contraction because of delayed solidification compared with the inside.

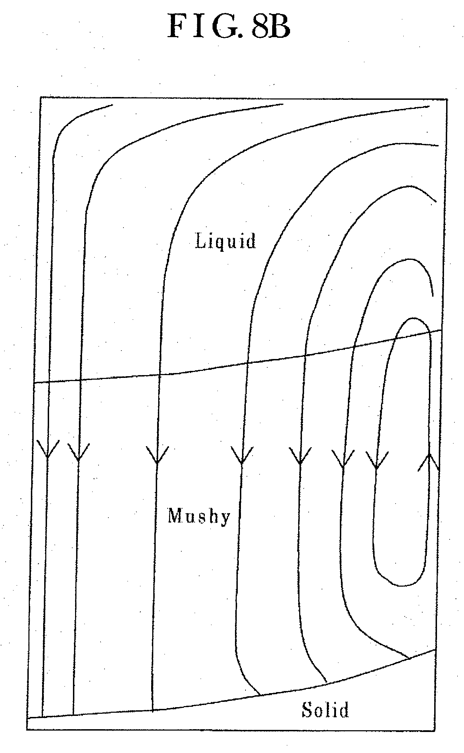

As the magnetic field intensity in the axial direction is increased, the flow in the radial direction is suppressed and the channel flow at the O.D. is eliminated, resulting in no macrosegregation. The flow pattern when Bz=10 Tesla is shown in FIG. 8(B). Although the upward flow is slightly seen at the O.D., it is very weak. And the radial flow is nearly completely suppressed with only the axial flow (flow due to solidification contraction) left. It is interesting to note such phenomena that while the flow to compensate for solidification shrinkage is maintained, only such flows excepting the gravitational direction (i.e. the convective flow or locally perturbed flow) which form channel segregation is suppressed. Although not shown here for want of space, the above phenomena were also observed in unidirectional solidifications in horizontal direction or in the opposite to gravitational direction (i.e. solidification from up to down). Furthermore, since the vigorous convection observed in the bulk liquid region was suppressed, the width of the mushy zone was broadened. These features by the application of static magnetic field work favorably for the productions of D.S. materials and especially of SX materials. That is that the occurrence of misoriented dendrite defects can be suppressed by enhancing stable dendritic growth.

B. Specific Example 2: Macrosegregation of unidirectionally solidified Ni-10 wt%Al Square Ingot

In order to investigate the influences of magnetic field directions on the formation of freckles, calculations were done for square ingots. The dimensions of cross section were determined to have the equivalent cross-sectional area to that of the Specific Example 1, i.e., 60 mm square. All other casting parameters are the same as those of round ingot (refer to Table 2). Computations were performed for 1/4 cross-sections considering the symmetricity. The number of elements for the ingot is 23004 (18 in X dir. x 18 in Y dir. x 71 in Z dir.).

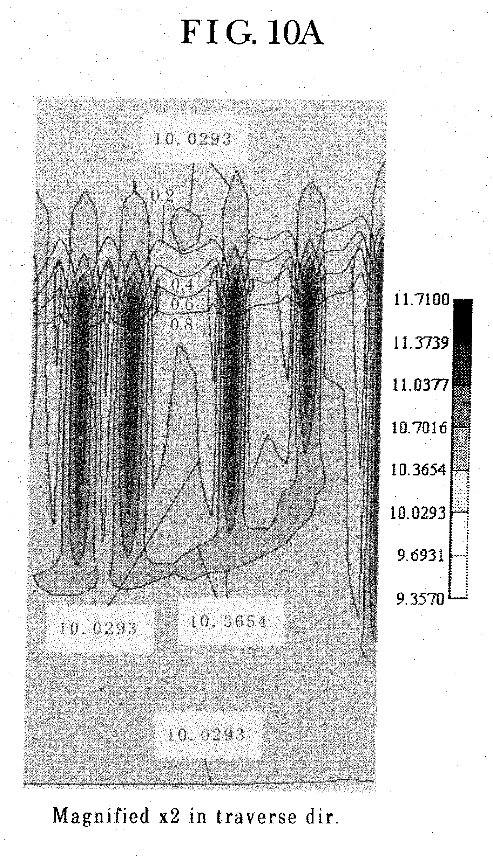

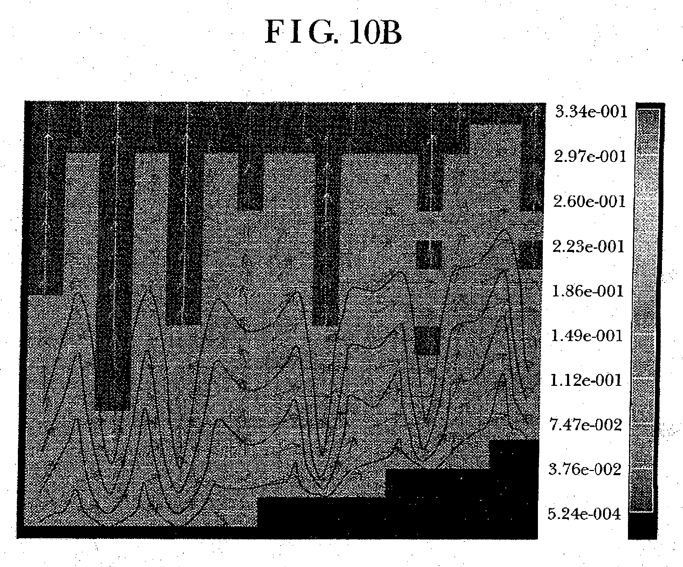

The macrosegregations of the conventional ingot with no magnetic field are shown in FIGS. 9 to 11. As shown in FIGS. 9(A) and 9(B), the freckles take place in vertical sections at outsides with roughly equal intervals. The maximum value of C/Co is about 1.18. FIGS. 10(A) and 10(B) show the states of macrosegregation being formed after 20 minutes during solidification (solidification time is 28.5 minutes). As in the case of the Specific Example 1, the liquid adjacent to freckles flows into and ascends along the channels as shown in FIG. 10(B), retarding solidification as shown by vol. fraction solid contours in the same figure. The freckles were formed by these ascending flows (refer to FIG. 10(A)). The suppressing effects on macrosegregation by the use of the magnetic field in axial direction are shown in FIG. 11. FIGS. 11(A), 11(B) and 11(C) show the macrosegregations in the vertical sections at the ends of Y dir., and FIG. 11(D) Al concentration distributions along XX' of FIG. 11 (91.9 mm from the bottom). From these diagrams, the suppressing effect is small with Bz=1 Tesla, but the segregation is practically eliminated above Bz=3 Tesla. The flow patterns in the mushy zones have become essentially the same as in the Specific Example 1 so that the flows in traverse directions have been suppressed with only axial downward flows left (not shown for brevity).

Next, an example of the case that uniform static magnetic field is exerted in horizontal direction (Y dir.) is shown in FIG. 12 (By=3 Tesla), indicating only slightly more effective compared to the case with Bz=3 Tesla. Thus, it was found that regardless of the magnetic field direction, suppressing effects on interdendritic fluid flow is virtually the same. In the above all computations, the electric boundary conditions at ingot and mold boundaries were set all insulated.

C. Macrosegregation of Unidirectionally Solidified Ni-10 wt%Al Thin Plate Ingot

The configuration of the real turbine blades mentioned in the Background Art is fairly complicated partially with thin-wall thickness (for example, refer to FIG. 1, p.320 and FIG. 5, p.321 of Ref. (1)). Considering this, the effects of magnetic field were studied with respect to the unidirectional solidification of 6 mm thick, 60 mm wide and 126 mm long-thin plate ingot. The casting conditions are given in Table 2. The same casting conditions were employed as before excepting that the heat extraction rate from the side wall was reduced to one tenth compared to the above-mentioned round and square ingots in order to retard the solidification from the side wall of mold. The computations were done for 1/4 cross-section considering symmetricity. The number of elements for ingot is 6390 (18 in X dir. x 5 in Y dir. x 71 in Z dir.). The results are shown in FIG. 13. In the case of the conventional ingot with no magnetic field, the freckles take place at the corner of the ends of X and Y directions (refer to FIG. 13(A)). When exerting the magnetic fields of 1, 2 and 3 Tesla in the axial direction, the segregation was practically vanished with 2 Tesla as shown in FIGS. 13(B) and 13(C). From these figures, the maximum values of C/Co are 1.13 for Bz=0 and 1.022 for Bz=1 Tesla so that the application of 1 Tesla exhibits sufficient effectiveness.

Furthermore, the application of uniform magnetic field in width direction (X dir.) or in thickness direction (Y dir.) yielded almost identical results as in the case applied in the axial direction (not shown for brevity). Next, the influences of casting conditions and the shape of blade were investigated. With respect to the casting conditions, the withdrawal rate of the mold was reduced down to 1.667 mm/min from 5 mm/min of Table 2; and the temperature of the susceptor was held at 1773K, (emissivity) in the radiation heating region 0.05, (emissivity) in the radiation cooling region 0.02, h (heat transfer coefficient) at the bottom 0.001 cal/cm 2 sec°C so that the temperature gradient in solidification range became about 45°C/cm at the middle of the blade length (these conditions match with practical operating range, and were set here for the convenience of computations). When the mold was withdrawn at the above-mentioned constant rate, the temperature gradient became about 50°C/cm for the former half period and decreased to about 25°C/cm for the latter half period. In addition, single crystal selector, etc. necessary for the production of SX material were omitted.

Moreover, considering that the cross-section of real turbine blade has curvature, that inner core is buried within blade wall thickness region, and thus that the wall thickness is not uniform, a taper was padded for the cross section (hereafter called tapered ingot. The ingot with no padding is called straight ingot). And the influences of the change in the wall thickness were investigated with the wall thickness at the center of the cross-section set 6 mm and those at both ends 3 mm. The 1/4 symmetric cross section was taken for computation. The inner core was neglected. The computation was also done for the case that the blade length was doubled (252 mm long). The above casting parameters were applied as to the straight blade with 126 mm long (number of elements 6390) and tapered blade with 126 mm long (number of elements 5751). With respect to the straight blade with 252 mm long (number of elements 12780), ε in the radiation cooling region was set 0.01 and the rest of all the other parameters were set the same as above.

The computational results are shown in FIGS. 19 to 21. FIG. 19 shows the contours of Al concentration of the above three unidirectionally solidified conventional ingots with no magnetic fields exerted. The diagrams of the vertical sections show the contours at the centers of wall thickness and those of the cross-sections the contours at the positions XX'. In either of the ingots, the freckles do not take place at the peripheral surfaces formed in the Specific Example 1 (round ingot of FIG. 6) or in the Specific Example 2 (square ingot of FIG. 9), but rather take place inside the ingots. This is considered attributed that the temperature difference between surface and inside of the ingot was almost vanished by radiation heating from the susceptor (the temperature at the outside is only slightly higher). It was also found that the freckles were considerably shortened as compared to those in the Specific Examples 1 and 2 where the freckles were elongated in the vertical direction reaching the top of the ingots.

In the tapered ingot of 126 mm long, the freckles tend to take place more markedly in the inside, particularly in thick-walled region. The profile of the mushy zone and the interdendritic liquid flow at the central vertical section, after 1005 sec from the start of withdrawal is shown in FIG. 20 (the flow pattern only in the mushy zone shown). The lines in the figure denote the contours of vol. fractions solid with the interval of 0.2 from 0.2 to 1.0. The flow velocity at the origin or the starting point of freckle (45 mm from the bottom) is the order of $3 \times 10^{-2}$ cm/s, and the velocity in traverse direction the order of $10^{-3}$ cm/s. The mushy zone profile is slightly inclined from the central thicker walled portion toward the end, and the interdendritic liquid flows from the end toward the center and a strong upward flow is seen at the origin of freckle. Also, it can be seen from the contours that the solidifications are delayed in the freckling sites compared to the surroundings. In the 252 mm long straight ingot (blade length doubled), the freckles formed more prominently and their lengths became longer (refer to FIG. 19(C)).

The magnetic fields of Bz=0.5, 1.0, 3.0 and 5.0 Tesla were exerted in the axial directions for the above-mentioned three ingots (the results not shown for want of space). In either of them, the freckles disappeared at Bz=0.5 Tesla, and at Bz=3 Tesla the macrosegregations of Al in the product region were improved to the level of 9.95 to 10.04 (wt%) except for the top of the ingot where shrinkage takes place and for the bottom connecting to seed crystal or single crystal selector. FIG. 21 shows the effects of magnetic fields (Bz=0.5, 3 and 5 (Tesla)) for the tapered 126 mm long ingot. In either of the ingots, there was no freckle formation and the negative segregation at thinner walled side (right end) was decreased with increasing magnetic field. This is because the very slow flow in the traverse direction as shown in FIG. 20 was effectively suppressed.

As above stated, the site of the formation and the morphology of freckles vary depending on casting parameters such as heating/cooling conditions, withdrawal rate, and the shape of blade. However, in any of these cases, it was clarified that the macrosegregations can be suppressed by exerting strong magnetic field.

D. Specific Example 4: Macrosegregation of Remelting-Processed IN718 Ni-Base

Superalloy Ingot

The chemical compositions and physical properties used for computations are given in Table 3. The chemical compositions and the relationships between temperature vs. liquidus compositions and temperature vs. solidus compositions respectively in the multicomponent system of IN718 were reproduced from FIGS. 1 to 3 of Ref. (10). Hence, the computational results of the relationship between temperature and vol. fraction solid (refer to FIG. 2), and the variations of solute concentrations in liquid phase during solidification (refer to FIG. 4) are the same as those of Ref. (10). Also, the variation of the liquid density by Eq.(8) is shown in FIG. 5, indicating that the alloy is of downward type of buoyancy.

Van Den Avyle, et al. reported in the aforementioned Ref. (2) that freckles formed in the middle of radial direction and 'central' freckles formed at the center in remelting-processed IN718 and Alloy 625 Ni-base superalloys ingots respectively. In these remelting processes, the depths of the mushy zone tend to deepen toward the center because of heat extraction from the side, leading to channel segregation even in the case of downward type alloy of buoyancy like IN718. The chemical compositions of IN718 studied in this description are regarded approximately equal to those of the Alloy 625 rather than those of the IN718 of Ref. (2). In the light of Ref. (2), the dimensions of ingots and the casting parameters were set as shown in Table 2. The re-melted molten droplets were cast into static mold at constant melting rate. In real operations, the heat transfer at ingot-water cooled copper mold boundary is greatly influenced by air gap formation, etc., and so it is very difficult to establish accurate thermal boundary conditions. Therefore, for the convenience of computation, instead of the water-cooled mold, fictitious hot plate and cylinder were placed at the bottom and at the O.D. of the ingot respectively. These plate and cylinder were assumed made of the same material as ingot. And the heat transfer coefficients at the bottom and at the O.D. of this fictitious mold were adjusted so that the solidification mode such as mushy zone profile become realistic in reference to the above Ref. (2). Furthermore, the correction factor $\alpha$ of the specific surface area of dendrite Sb was set 0.6 in accordance with the freckle formation in Ref. (2). The number of elements for ingot is 4800 (40 in radial dir. x 120 in axial dir.).

The computational results are shown in FIGS. 14 to 16. FIGS. 14 and 16 show the contours of Nb concentrations and distributions respectively. FIG. 15 shows the distributions of alloy compositions in radial direction (1068.8 mm from the bottom) with no magnetic field. The central freckles reported in the Alloy 620 of the above Ref. (2) have formed as shown in FIG. 14(A). Yet, in the IN718 of this specific example, conventional type of freckles did not take place in the middle of the radial direction. These results coincide well with the observations given by Ref. (2), showing the validity of the numerical method described in this description. It is seen from FIG. 15 that positive segregations take place for Al, Ti and Nb with the equilibrium partition ratios less than 1 and negative segregations for Cr and Fe with the partition ratios greater than 1. To investigate the effects of magnetic field, computations were done changing the magnetic field intensities in the axial direction from Bz=3 to 10 Tesla, and it was found that at Bz=10 Tesla the macrosegregation was reduced to practically acceptable level (refer to FIGS. 14 and 16).

Thus, in the above Specific Examples 1 to 4, it was concretely shown that the macrosegregations were caused by the interdendritic liquid flow within the mushy zone and that their flow patterns were the most critical factors.

More importantly, this inventor has shown for the first time that the extremely slow interdendritic fluid flow responsible for the formation of macrosegregation can be suppressed by exerting high magnetic field onto the whole mushy zone, and thereby made it clear that the macrosegregations such as freckles can essentially be eliminated. Despite that the electromagnetic braking effect on molten metals has long been recognized, there has been no literature, to the best of this inventor's knowledge, showing that the macrosegregation can be eliminated by the application of magnetic field.

Bellow, the electromagnetic braking effects by this invention will be discussed along with the key points of this invention.

(1) Now, take an electromagnetic fluid that flows at a constant velocity V in traverse direction (suppose X dir.) perpendicular to the direction of the gravity. When exerting a magnetic field B in the direction perpendicular both to V and gravity, the electromagnetic braking force is given by $f_x = -\sigma B^2 v$, provided that E of the aforementioned Eq.(1) is regarded as 0 because the electric conductivity $\sigma$ of metals are generally high. In such a case, the momentum equation is expressed as

$$\rho \frac{dv}{dt} = -\sigma B^2 v \qquad \dots\dots\dots\dots\dots\dots\dots (9)\,.$$

Integrating the above equation with the initial condition of V=Vo at time t=0,

$$\frac{v}{v_0} = \exp(-\frac{\sigma B^2}{9.8\rho}t) \qquad \dots\dots\dots\dots\dots\dots (10)$$

where, the units are V (m/s), $\sigma$ (1/$\Omega$m), B (Tesla), $\rho$(Kg/m3) and t (sec) respectively. From Eq.(10), it is understood that V decays exponentially with time, and that the higher the $\sigma$ and the lower the $\rho$, the lower the V. For example, taking $\sigma$=10$^6$, $\rho$ =7300 and B=0.1 becomes V/Vo=exp (-0.14t). From this, V/Vo=0.5 after t=2.15 sec, and further V/Vo=0.25 after t=4.3 sec. Also, taking $\sigma$=5x10$^6$, $\rho$=2700 and B=0.1 for Al alloy, V/Vo=exp(-1.9t); again V/Vo=0.5 after t=0.15 sec, and further V/Vo=0.25 after 0.3 sec. From these rough estimates, it can be understood that low magnetic field as low as B=0.1 Tesla can effectively suppress molten metal flow within bulk liquid pool.

Next, taking electromagnetic braking force f (EMB force) as X in Eq. (6) and defining $\pi$ as the ratio of f to the Darcy's flow resistant force v $\mu$ g$_L$/K (refer to Eq. (6)), $\pi$ is given by

$$\pi = \frac{\text{EMB force}}{\text{Darcy's flow resistant force}} = \frac{f}{v\mu g_L / K} \qquad \dots\dots (11)\,.$$

$\pi$ is a dimensionless number representing EM braking effect on the interdendritic fluid flow within the mushy zone. f is given by f = $\sigma$(-$\nabla\phi$ + v x B) x B from Eqs.(1) and (4). For the convenience of discussion, consider the same situation as above described, i.e., the EMB force is exerted against an uniform flow in traverse direction within the mushy zone. Then Eq.(6) becomes

$$v = \frac{K}{\mu g_L}(-\frac{\partial P}{\partial x} - \sigma B^2 v) \qquad \dots\dots (12)\,.$$

It is seen from the above equation that for a flow of V>0, EMB force (-$\sigma$B$^2$v) acts in the opposite direction to the flow (in the opposite direction to pressure gradient force -$\partial$P/$\partial$x(>0)). Thus, it acts as a braking force (for a flow of V<0, it similarly acts as brake). Solving Eq.(12) with respect to V yields the following equation.

$$v = \frac{-K/\mu g_L}{1 + \sigma B^2 K/\mu g_L} \cdot \frac{\partial P}{\partial x} \qquad \dots\dots (13)$$

Regarding v$_0$ as the velocity with no magnetic field in the above equation and using $\pi$ defined in

Eq.(11), the ratio V/Vo is given as follows.

$$\frac{v}{v_0} = \frac{1}{1+\pi}; \quad \pi = \frac{\sigma B^2 K}{\mu g_L} \quad \dots\dots\dots\dots\dots (14a, 14b)$$

Thus, V decays hyperbolically with increasing $\pi$. In real casting processes, K and gL change depending on the location and the time. Here, using typical values of these parameters in the above Specific Examples 1 to 4, $\pi$ were calculated for the values of B when the segregations such as freckles were suppressed. The results are shown in Table 4 (as to the unit conversion of $\sigma B^2$, note $1T^2/\Omega m = 10^{-3} dyn \cdot sec/cm^4$).

Table 4 Approximate values of dimensionless numbers $\pi$ and $\phi$

| Best mode of invention | A | B | C | D |
|---|---|---|---|---|
| Magnetic field density to suppress macrosegregation, B(T) | 10 | 3 | 2 | 10 |
| $K(cm^2)$ and representative value of $g_L$ | $K=1.467 \times 10^{-6}$ $g_L=0.584$ | $K=1.311 \times 10^{-6}$ $g_L=0.603$ | $K=2.257 \times 10^{-6}$ $g_L=0.479$ | $K=1.096 \times 10^{-6}$ $g_L=0.574$ |
| $\pi$ | 5 ($0.05B^2$) | 0.39 ($0.043B^2$) | 0.38 ($0.094B^2$) | 2.73 ($0.027B^2$) |
| $\Delta \cdot \rho_L/\rho_L$ | 0.033 | 0.033 | 0.033 | 0.034 |
| v(m/s) | $5 \times 10^{-5}$ | $5 \times 10^{-5}$ | $5 \times 10^{-5}$ | $2.5 \times 10^{-5}$ |
| $\Delta \rho_L g_r (N/m^3)$ | 2254 | 2254 | 2254 | 2548 |
| $\phi$ | 2.2 | 0.2 | 0.09 | 0.98 |

In the case of the Specific Example 1, $\pi=0.05 B^2$: From this, taking Bz=5 Tesla, $\pi=1.25$ so that V is reduced to V/Vo=0.44; and taking Bz=10 Tesla, $\pi=5.0$ so that V is reduced to V/Vo=0.17. From Table 4, however, there are large discrepancies in the values of $\pi$ to suppress segregation. As will be discussed in the next paragraph (2), since the configurations and the degrees of segregation differ in individual cases, it is difficult to determine the values of $\pi$ necessary to suppress the segregation. Despite that, it would be a useful parameter. For example, below B=1 Tesla, $\pi<<1$ meaning there is almost no suppressing effect on segregation.

(2) The main factors for determining the interdendritic liquid flow pattern within the mushy zone in real casting processes are as follows.

I. Buoyancy force due to liquid density difference $\Delta \rho_L$ within the mushy zone (i.e. $\Delta \rho_L g_r$ where $g_r$ is the acceleration of gravity)
II. Mushy zone profile
III. Permeability K determined by dendrite morphology (refer to Eq.(7))

$\Delta \rho_L g_r$ is a driving force to cause convective flow in the mushy zone and is determined by the chemical compositions of the alloy. There are upward type and downward type of buoyancies along with the mixture type of these two. The factors II and III are determined by the cooling condition in each casting process. Thus, there exist a variety of cases. To take a couple of examples, the most important factor for the formation of freckles in unidirectionally solidified turbine blade of upward type alloy of buoyancy is $\Delta \rho_L g_r$ (factor I). And thus the freckles take place above a certain value of $\Delta \rho_L$ or $\Delta \rho_L g_r$. On the contrary, the contribution from the factors II or III is relatively small. In the case of ingot making via remelting process for downward type alloy of buoyancy, if the mushy zone profile is flat or considerably shallow, macrosegregation does not occur regardless of the factor I or III. However, in the Specific Example 4, the profile of the mushy zone was inclined to the direction of gravity and therefore the downward flow was induced due to the factor I (downward buoyancy), resulting in the central segregation. Even in this case, as the diam of ingot is reduced with reduced K, segregation is unlikely to take place. [The smaller the dendrite arm spacing (DAS), the smaller the K. In general, as DAS becomes smaller with increased cooling rate, the convective flow due to the factor I vanishes and channel segregation or freckles does not occur.]

Therefore, as another dimensionless number to evaluate the effect of EMB force, it is useful to define the ratio of EMB force to buoyancy. That is

$$\phi = \frac{\sigma B^2 v}{\Delta \rho_L \, g_r} \qquad\qquad ................................ (15).$$

The value of the dimensionless number $\phi$ calculated for average rough values of V and the required values of B are shown in Table 4 (note the unit conversion of $\sigma B^2$).

From the above discussions (1) and (2), it is understood that while low magnetic field less than 1 Tesla (say 0.1 Tesla) is sufficient to suppress high speed flow in bulk melt region (generally, the order of 10 cm/s in remelting processes), high magnetic field is required to suppress extremely slow interdendritic flow within the mushy zone (typically, the order of $10^{-2}$ to $10^{-4}$ cm/s).

As a rough guideline to evaluate the magnitude of the high magnetic field, the dimensionless numbers $\pi$ or $\phi$ defined respectively by Eq.(14) or Eq.(15) are meaningful: In practice, by knowing the limiting empirical values $\pi_C$ or $\phi_C$ necessary to suppress segregation for individual alloy systems and casting processes, B can be determined so as to satisfy $\pi \geqq \pi_C$ or $\phi \geqq \phi_C$. It is economical to evaluate $\pi_C$ or $\phi_C$ in scaled down experiments, where the numerical analysis described in this description can be very useful.

From the above Specific Examples, it has been shown that regarding relatively small sized turbine blades having thin wall thickness, the magnetic fields above approximately 0.5 Tesla can effectively improve the defects such as freckles and misoriented grains. [It is well known that solidification interface morphology changes from flat to cell and further to dendrite as the value of G/R is decreased (G is the temperature gradient in liquid phase at the interface, R is the moving rate of the interface), and it has been considered that in the case of SX ingot, single crystal growth breaks down below a certain value of G/R to form foreign crystal, i.e., misoriented grain structures (For example, see Ref. (15)). It is also known that grain structure coarsens with the application of magnetic field during solidification, which means that the misoriented grains are not likely to take place. This is considered attributed that the stable single crystal growth is promoted by the application of magnetic field and thereby suppressing the liquid flow.]

On the other hand, in the case of large sized remelted ingot, the magnetic field of at least 1 Tesla would be necessary. However, as already stated, these lower limit values of the magnetic field are just rough guidelines on the condition of optimized casting parameters, and change depending on individual cases. They are also subject to quality requirement.

(3) The suppressing effect on the liquid flow within the mushy zone does not depend on the directions of the magnetic field. Hence, the most suitable configuration may be employed for individual processes. Yet, note that in the above all examples, the ingot-mold boundaries were all electrically insulated. Although uniform static magnetic fields were applied in the above computations, they do not need to be rigidly uniform.

(4) The schematic diagram when exerting static magnetic field for unidirectional solidification is shown in FIG. 1(B). As mentioned in the Background Art, typical directional solidification apparatus comprises various components such as chill, mold heating furnace, withdrawal unit, vacuum chamber, etc. Beside, there are various configurations. For example, it is possible to make use of zone melting where at first a small amount of metal is remelted from once solidified ingot and then slowly move this molten band from one end to the other (For example, refer to p.2 of Ref. (3)).

In short, this invention is aimed at the method and apparatus for unidirectional solidification of castings and ingots, where solid, mushy and bulk liquid zones are made to form and then solidification is done by moving these zones from one end to the other. Thus, it is obvious in principle that this invention can be applied to all directional solidification processes. Real unidirectionally solidified turbine blades posses complicated shapes. Ref. (11) describes a technology to make single crystal structure (SX) in thin blade region and polycrystalline columnar dendrite structure (DS) in platform region. This invention can be applied to such a mixed grain structure as well. It is also possible, as already mentioned, to apply to the cases where solidification is done in horizontal direction perpendicular to gravity or in the opposite to gravity (i.e. from up to down). Some of the DC coils 5 used in this invention are shown in FIG. 18. Solenoid type (A), 1-unit coil (B), 2-units coils (C), etc. are available for the case to exert the magnetic field in vertical direction. Race track typed 1-unit coil (D), race track typed 2-unit coils, etc. can be used for the case to exert in horizontal direction. Superconductive coils are highly recommended for these coils. In practice, various designs for coils are possible and the most suitable design may be employed depending on the shape of casting, the direction of solidification, the required magnitude of magnetic field and so on.

(5) Generally in remelting processes such as VAR and ESR, strong electric current flows through the mushy zone and interacts with externally applied magnetic field to generate electromagnetic force (Lorentz force). This is not desirable. Therefore, it is necessary to employ an alternative method that does not flow electric current in the ingot. One of such examples is shown in FIG. 17 where (A) is the case applied to ESR. Reference symbol 5 denotes DC coils for generating the magnetic field either in vertical or in horizontal direction. As mentioned in the above item (4) regarding the coil, superconductive coils are highly recommended. The electrodes 1 are placed remote from the DC coils to prevent the influence of the magnetic field. The molten slag pool 2 is heated by the heat of Joule generated by the electric current between the electrodes, and thereby the electrodes are melted. Further, the slag pool is heated and maintained at a prescribed temperature by the heater 4 placed at the O.D. of insulating refractory sleeve 3. The molten droplets melted from the electrodes flow down through the slag pool, are refined and are solidified. The ingot 7 is withdrawn downward by flexible platform 9 while being cooled from the bottom by water-cooled chill 8. Because the molten slag gets into the opening between the ingot and the water-cooled mold 6 and also air gap forms there (not shown), the cooling rate from the O.D. is relatively low.

Another desirable example is shown in FIG. 17(B) which combines VAR and slag refining and the high magnetic field by this invention. Space 10 is of vacuum or inert gas atmosphere. The electrodes are remelted by high electric current arc (usually DC). High quality ingots with high purity and no segregation can be produced by the application of high magnetic field in addition to the beneficial effects of VAR and slag refining. In these processes, the magnetic shield 11 is installed in order to insulate the high electric current field around the electrodes from the magnetic field. Various designs are possible as illustrated in FIG. 17.

In summary, the following configurations are possible:

> ESR + High Magnetic Field
> VAR + High Magnetic Field
> VAR + Slag Refining + High Magnetic Field, etc.

(6) It is well known that the solid-liquid interface morphologies during solidification of alloy can be determined by the aforementioned parameter G/R based on the theory of constitutional undercooling. In the production of true single crystal such as semiconductor Si, G and R are respectively independently controlled (be it Bridgeman's method or Czochrolski's method); and by increasing G with decreasing R (thus increasing G/R), the flat interface (or stable interface) can be obtained. [In general the amounts of the alloying elements contained in these true single crystals are extremely small, and no mushy zone exists (or not allowed). Hence, they are totally different from the dendrite structures having mushy zone (be it DS or SX material) defined in this description.]

It is known that the redistribution of alloy compositions in growth direction of single crystal is greatly changed by the convection of liquid in front of the flat interface (For example, refer to p.42, FIG. 2-9 of Ref. (3)).

Ref. (12) discloses a technique to reduce a large change in solute composition(s) distribution in growth direction of single crystal semiconductor, which is caused by convection of liquid in front of the flat interface. In this technique, the crystal is grown from a starting material with non-uniform solute distribution to obtain more uniform single crystal. Furthermore, it aims to produce the single crystal with more uniform composition(s) by growing in the opposite direction to once grown direction or by exerting magnetic field (about 0.2 Tesla) to suppress the convection. Thus, this technique of Ref. (12) intends to suppress the convection in front of the growing flat interface in true single crystal growth with no mushy zone. Hence, it is different from this invention.

Ref. (13) discloses a single crystal growth technique by Bridgeman's method to obtain better crystal(s) with as less a number of crystals as possible. In this technique, a material having the positive change of magnetic susceptibility at the melting point of liquid-solid transition (i.e. the magnetic susceptibility of solid is higher than that of liquid) is used. And by applying the magnetic field during growth, thereby enhancing the energy barrier for the formation of nuclei, the number of crystals can be reduced. Thus, the technique by Ref. (13) is different from this invention.

As G/R is decreased, the stable flat interface growth breaks down with solid intruding into liquid phase, thus resulting in cellular structure. As G/R is further decreased, the dendrite structure results. In the case of cellular growth, the mushy zone consists of cells and liquid phase, and so this invention can be applied. Thus, by applying high magnetic field and thereby suppressing the intercellular liquid flow, it is possible to obtain cellular structure without segregation.

(7) Ref. (14) discloses a technique for reducing macrosegregation of Al-alloy continuous castings by exerting the magnetic field of maximum 0.15 Tesla onto the molten metal pool. [In continuous casting, the liquid flow rate within the melt pool is the order of 10 to 100 cm/s. As abovementioned in the items (1) and (2), the magnetic field as low as 0.1 Tesla can effectively suppress such high speed flow, but it can not induce the braking force against the extremely slow liquid flow within mushy zone.] There is no word in this reference concerning the mechanism for reducing the macrosegregation. Furthermore, grain refiners have been added in all the experiments done in this reference. This point deserves attention. With respect to the suppressing effect on the macrosegregation in the case of Ref. (14), this inventor considers as follows: As a result of reduced convection within the bulk liquid pool by the applied magnetic field, the grain refining effect was enhanced compared with the case of no magnetic field. And thus, grain structure became that of finer equiaxed grains leading to less macrosegregation in the central region of the ingot.

[In general, one of the objectives to add grain refiners is to obtain finer equiaxed grain structure and thereby to reduce segregation. However, the vigorous convection in the liquid pool increases the chances of the cohesion/ coalescence/ coarsening of grain refiners and therefore decreases the refining effect. Then, it is thought that exerting magnetic field reduces such chances caused by the vigorous convection and retains the refining effects.] Thus, it is an indispensable condition to use the grain refiners together with the magnetic field. And as a result of enhancing grain-refining effect, the macrosegregation was indirectly reduced. If an inappropriate magnitude of magnetic field is applied for the case with no grain refiners, the reduced convection within the liquid pool is likely to develop coarsened columnar grain structure and the central macrosegregation may contrarily worsen.

On the other hand, the essence of this invention is that the macrosegregation such as freckles can completely be eliminated in unidirectional solidification (where in principle grain refiners must not be used) or remelting processes by exerting the magnetic field onto the whole mushy zone with the magnitude necessary to suppress the extremely slow interdendritic liquid flow. The viewpoint of this invention is thus totally different from that of Ref. (14), and hence different in terms of casting process, exerting region and the magnitude of the magnetic field.

Industrial Applicability

It has been clarified from the above Specific Examples 1 to 3 that by exerting high magnetic field, it is possible to completely eliminate the macrosegregation such as freckles observed in DS or SX Ni-base superalloy castings practically in use at present. Many of these alloys are of upward type of buoyancy. This invention can effectively be applied to even stronger buoyant alloys (with large $\Delta\rho_L g_r$ within mushy zone) which are not unidirectionally castable because of severe segregation. This means that this invention enhances the freedom of alloy selection, or opens the possibility to develop stronger alloys at elevated temperatures (for example, the vol. fraction of $\gamma'$ can be increased to an upper limit).

It has been shown in the Specific Example 4 that this technology is effectively applied to the remelting-processed ingot of downward type IN718 alloy of buoyancy, but it is also apparent from the Specific Examples 1 to 3 to be applicable to usual alloys of upward type of buoyancy. Thus, this invention enables it possible to make large diam remelted ingots of upward buoyancy type.

Finally, the benefits of this invention can be summarized as follows:

1. The macrosegregation such as freckles can completely be eliminated.
2. The melting off of dendrites due to convective liquid flow can be prevented, which makes it possible to grow perfect mono-crystals (SX) without misoriented grain defects.
3. As a result of these benefits, it will become possible to develop new types of alloys where the volume fraction of $\gamma'$ can be increased to a maximum limit.

Thus, this invention makes it possible to produce unidirectionally solidified castings such as high quality turbine blades or remelting-processed ingots, which greatly contributes to the safety of important mechanical components and to the energy conservation by enhancing the efficiency of gas turbine engines. Considering the present situation that high magnetic field can be obtained at relatively low cast owing to the recent progress in superconductive technology, there seems no barrier to realize this invention. Therefore, the industrial merits are very high. In this description, two types of Ni-base alloys were examined as shown in the Specific Examples. However, it is apparent in principle that the similar benefits can be obtained for all alloy productions: For example, directionally solidified AlTi base alloy turbine blades, low alloy steels, etc. as well as all Ni-base alloys.

References

(1) ASM Handbook Vol. 15 Casting (1988)
(2) J. A. Van Den Avyle, J.A. Brooks, and A.C. Powell: "Reducing Defects in Remelting Processes for High-Performance Alloys", JOM, 50 (3) (1988) pp.22-25, 49
(3) M. C. Flemings: "Solidification Processing", McGraw-Hill, Inc., (1974)
(4) P. C. Carman: Trans. Inst. Chem. Eng., Vol. 15 (1937), p.150
(5) Japan Patent 3747216 or US Patent 6241004B1 (2001)
(6) A. F. Giamei and B. H. Kear: "On the Nature of Freckles in Nickel Base Superalloys", Metallurgical Transactions, Vol. 1 (1970), pp.2185-2192
(7) T. Iida and R. I. L. Guthrie: The Physical Properties of Liquid Metals, Clarendon Press, Oxford, United Kingdom (1993), pp.70-73
(8) P. N. Quested and M. MacLean: "Solidification Morphologies in Directionally Solidified Superalloys", Materials Science and Engineering, Vol. 65 (1984), pp.171-184

(9) M. C. Schneider, J. P. Gu, C. Beckermann, W. J. Boettinger and U. R. Kattner: "Modeling of Micro- and Macrosegregation and Freckle Formation in Single-Crystal Nickel-Base Superalloy Directional Solidification", Metallurgical and Materials Transactions A, Vol. 28A (1997), pp.1517-1531

(10) W. J. Boettinger, U. R. Kattner and S. R. Coriell, Y. A. Chang, and B. A. Mueller: "Development of Multicomponent Solidification Micromodels Using a Thermodynamic Phase Diagram Database", Modeling of Casting, Welding and Advanced Solidification Processes VII, Edited by M. Cross and J. Campbell, The Minerals, Metals and Materials Society (1995), pp.649-656

(11) Published Japanese patent application, H07-145703 (1995)

(12) Published Japanese patent application, H09-227268 (1997)

(13) Published Japanese patent application, H06-48882 (1994)

(14) US Patent 5246060 and US Patent 5375647

(15) T. M. Pollock and W. H. Murphy: "The Breakdown of Single-Crystal Solidification in High Refractory Nickel-Base Alloys", Metallurgical and Materials Transactions A (1996), Vol. 27A, pp.1081-1094

**Claims**

1. A unidirectional solidification process for producing, from a Ni-base alloy which exhibits a solid-liquid coexisting phase during solidification, castings or ingots having a single crystalline dendrite grain structure (SX), or a polycrystalline columnar dendrite grain structure (DS), or a mixed grain structure of the single crystalline dendrite grain structure and the polycrystalline columnar dendrite grain structure, said process comprising:

   Step (1): forming a solid phase, a solid-liquid coexisting phase and a liquid phase in a casting or ingot, and moving said solid-liquid coexisting phase from one end of said casting or ingot toward the other end thereof to establish unidirectional solidification; and
   Step (2): during said step (1), exerting onto the whole region of said solid-liquid coexisting phase a static magnetic field in the axial direction of the casting or ingot and of a magnitude necessary to suppress the interdendritic liquid flow in traverse directions within said solid-liquid coexisting phase, and thereby to suppress the formation of macrosegregation.

2. The unidirectional solidification process according to claim 1, wherein, in said step (2), the static magnetic field is applied to supress the formation of misoriented grain defects in the grain structure.

3. The unidirectional solidification process according to claim 1 or 2, wherein, in the case of cellular growth where the solid-liquid coexisting phase consists of cells and liquid phase, the magnetic field is applied in step (2) to suppress the intercellular liquid flow in traverse directions to obtain a cellular structure without segregation and/or without misoriented grain defects.

**Patentansprüche**

1. Ein unidirektionaler Verfestigungsprozess zum Herstellen, aus einer Ni-Basis-Legierung, welche eine Fest-Flüssig-Koexistenzphase während der Verfestigung zeigt, von Gussteilen oder Rohblöcken mit einer einkristallinen Dendrit-Kornstruktur (SX) oder einer polykristallinen Säulen-Dendrit-Kornstruktur (DS), oder einer gemischten Kornstruktur aus der einkristallinen Dendrit-Kornstruktur und der polykristallinen Säulen-Dendrit-Kornstruktur, wobei der Prozess aufweist:

   Schritt (1): Ausbilden einer festen Phase, einer Fest-Flüssig-Koexistenzphase und einer flüssigen Phase in einem Gussstück oder Rohrblock, und Bewegen der Fest-Flüssig-Koexistenzphase von einem Ende des Gussstücks oder Rohblocks zu dem anderen Ende davon, um eine unidirektionale Verfestigung zu erreichen, und
   Schritt (2): während dem Schritt (1), Ausüben eines statischen Magnetfelds in der Axialrichtung des Gussstücks oder Rohblocks auf den gesamten Bereich der Fest-Flüssig-Koexistenzphase und mit einer Größe, die notwendig ist, um die interdendritische Flüssigkeitsströmung in Querrichtungen in der Fest-Flüssig-Koexistenzphase zu unterdrücken, um dadurch die Ausbildung von Makroseigerung zu unterdrücken.

2. Der unidirektionale Verfestigungsprozess gemäß Anspruch 1, wobei, in dem Schritt (2) das statischen Magnetfeld aufgebracht wird, um die Ausbildung vom fehlorientierten Korndefekten in der Kornstruktur zu unterdrücken.

**3.** Der unidirektionale Verfestigungsprozess gemäß Anspruch 1 oder 2, wobei, in dem Fall von Zellwachstum, wo die Fest-Flüssig-Koexintenzphase aus Zellen und einer Flüssigphase besteht, das magnetische Feld im Schritt (2) aufgebracht wird, um die interzellulare Flüssigkeitsströmung in Querrichtungen zu unterdrücken, um eine Zellstruktur ohne Segregation und/oder ohne fehlorientierte Korndefekte zu erhalten.

## Revendications

**1.** Procédé de solidification unidirectionnelle servant à produire, à partir d'un alliage à base de Ni qui présente une phase de coexistence solide-liquide pendant la solidification, des moulages ou des lingots ayant une structure de grains de dendrite monocristalline (SX), ou une structure de grains de dendrite colorinaire polycristalline (DS), ou une structure de grains mélangée de la structure de grains de dendrite monocristalline et de la structure de grains de dendrite colonnaire polycristalline, ledit procédé comprenant :

étape (1) : formation d'une phase solide, d'une phase de coexistence solide-liquide et d'une phase liquide en un moulage ou un lingot, et déplacement de ladite phase de coexistence solide-liquide d'une extrémité dudit moulage ou dudit lingot vers son autre extrémité pour établir une solidification unidirectionnelle ; et
étape (2) : au cours de ladite étape (1), application à toute la région de ladite phase de coexistence solide-liquide d'un champ magnétique statique dans la direction axiale du moulage ou du lingot et d'une amplitude nécessaire pour supprimer l'écoulement de liquide entre dendrites dans des directions transversales à l'intérieur de ladite phase de coexistence solide-liquide, et pour ainsi supprimer la formation d'une macroségrégation.

**2.** Procédé de solidification unidirectionnelle selon la revendication 1, dans lequel, au cours de ladite étape (2), le champ magnétique statique est appliqué afin de supprimer la formation de défauts de grains mal orientés dans la structure de grains.

**3.** Procédé de solidification unidirectionnelle selon la revendication 1 ou 2, dans lequel, dans le cas d'une croissance cellulaire durant laquelle la phase de coexistence solide-liquide est constituée de cellules et d'une phase liquide, le champ magnétique est appliqué au cours de l'étape (2) pour supprimer l'écoulement de liquide intercellulaire dans des directions transversales afin d'obtenir une structure cellulaire exempte ségrégation et/ou exempte de défaut de grains mal orientés.

# FIG. 1A

# FIG. 1B

# FIG. 2

Relationship between temperature and vol. fraction solid
of Ni-10Al and IN718 alloys

# FIG. 3

Variation of solute concentration in liqiud for Ni-10Al alloy

# FIG. 4

Variation of solute concentrations in liquid for IN718 alloy

# FIG. 5

Variation of liquid densities for Ni-10Al and IN718 alloys

FIG. 6A  Bz=0
9.9657
9.6071
9.2486
9.9657

R          R'

11.4000
11.0414
10.6829
10.3243
9.9657
9.6071
9.2486
8.8900

FIG. 6B  Bz=5T
10.0413

R          R'

10.7900
10.5404
10.2909
10.0413
9.7917
9.5421
9.2926
9.0430

FIG. 6C  Bz=10T
10.0206
(>10.0206)

R          R'

(<10.0206)

10.1500
10.0206
9.8911
9.7617
9.6323
9.5029
9.3734
9.2440

# FIG. 6D

Effect of magnetic field in axial direction on freckle segregates
(91.9mm from the bottom)

# FIG. 7A

Solid fraction isolines

# FIG. 7B

Solid fraction isolines
at portion A

# FIG. 8A

# F I G. 8B

**FIG. 9A** XX' cross-section

**FIG. 9B** Vertical section at the end of Y dir.

# FIG. 10A

Magnified x2 in traverse dir.

# F I G. 10B

FIG. 11A Bz=0

FIG. 11B Bz=3T

FIG. 11C Bz=5T

X ———————— X'

X ———————— X'

X ———————— X'

| 11.8400 |
| 11.4646 |
| 11.0891 |
| 10.7137 |
| 10.3383 |
| 9.9629 |
| 9.5874 |
| 9.2120 |

9.9629

10.3383

10.028

10.046

10.064

| 10.1000 |
| 10.0820 |
| 10.0640 |
| 10.0460 |
| 10.0280 |
| 10.0100 |
| 9.9920 |
| 9.9740 |

10.01

9.9766

9.9871

9.9977

10.0083

| 10.0400 |
| 10.0294 |
| 10.0189 |
| 10.0083 |
| 9.9977 |
| 9.9871 |
| 9.9766 |
| 9.9660 |

EP 2 011 588 B1

# FIG. 11D

Effect of magnetic field in axial direction on freckle segregates
(91.9 mm from the bottom)

# FIG. 12A XX' cross section

9.9742

9.9874

10.0403

10.0800
10.0668
10.0536
10.0403
10.0271
10.0139
10.0007
9.9874
9.9742
9.9610

# FIG. 12B Vertical section at the end of Y dir.

X — X'

10.0642

9.9998

10.0384

10.0256

10.0127

10.0900
10.0771
10.0642
10.0513
10.0384
10.0256
10.0127
9.9998
9.9869
9.9740

Z

Y X

Magnified x2 in traverse dir.

FIG. 13A Bz=0
10.0277~11.16% at corner

FIG. 13B Bz=1T
9.9510~10.08%

FIG. 13C Bz=2T
9.952~10.03%

X (x2 in Y direction)

X

9.9149

10.1179

10.3563

9.8794

11.3100
11.0716
10.8331
10.5947
10.3563
10.1179
9.8794
9.6410

9.9911

10.2200
10.1437
10.0674
9.9911
9.9149
9.8386
9.7623
9.6860

9.9477

9.9951

X'

10.0900
10.0426
9.9951
9.9477
9.9003
9.8529
9.8054
9.7580

Z

Y

X x2 in traverse dir.

F I G. 14A  Bz=0    F I G. 14B  Bz=5T    F I G. 14C  Bz=10T

R  x2 in R dir.

EP 2 011 588 B1

# FIG. 15

Distribution of alloy concentrations (1068.8mm from the bottom)

# FIG. 16

Effect of magnetic field in axial direction on Nb segregation
(1068.8mm from the bottom)

# F I G. 17A

Liquid

**B**

Mushy

7

Solid

# FIG. 17B

Vacuum seal

1 0

1

11    11

4    3

2

5    5

Liquid

B

Mushy

7
Solid

6

8

9

Cooling water

## FIG. 18A

Solenoid coil

Liquid+solid zone

## FIG. 18B

1-unit coil

Liquid+solid zone

## FIG. 18C

2-unit coils

Liquid+solid zone

## FIG. 18D

1-unit coil

Liquid+solid zone

## FIG. 18E

2-unit

Liquid+solid zone

FIG.19A Straight, 126mm long
9.418~10.930%

FIG.19B Tapered, 126mm long
9.303~11.430%

FIG.19C Straight, 252mm long
9.597~10.790%

# FIG. 20

Liquid

Solid

Center                                                    End

FIG.21A Bz=0.5T
9.726～10.12%

FIG.21B Bz=3T
9.993～10.06%

FIG.21C Bz=5T
10.02～10.06%

EP 2 011 588 B1

## REFERENCES CITED IN THE DESCRIPTION

**Patent documents cited in the description**

- JP 62227569 A
- JP 57184572 A
- US 4540038 A
- JP 3747216 B
- US 6241004 B1
- JP H07145703 B
- JP H09227268 B
- JP H0648882 B
- US 5246060 A
- US 5375647 A

**Non-patent literature cited in the description**

- **B.Q.LI.** Solidification Processing of Materials in Magnetic Fields. *JOM,* February 1998, vol. 50 (2
- **RIAHI D.N.** Effects of a vertical magnetic field on chimney convection in a mushy layer. *Journal of Crystal Growth,* 01 June 2000, vol. 216 (1-4), 501-511
- ASM Handbook. 1988, vol. 15
- **J. A. VAN DEN AVYLE ; J.A. BROOKS ; A.C. POWELL.** Reducing Defects in Remelting Processes for High-Performance Alloys. *JOM,* 1988, vol. 50 (3), 22-25, 49
- **M. C. FLEMINGS.** Solidification Processing. Mc-Graw-Hill, Inc, 1974
- **P. C. CARMAN.** *Trans. Inst. Chem. Eng.,* 1937, vol. 15, 150
- **A. F. GIAMEI ; B. H. KEAR.** On the Nature of Freckles in Nickel Base Superalloys. *Metallurgical Transactions,* 1970, vol. 1, 2185-2192
- **T. IIDA ; R. I. L. GUTHRIE.** The Physical Properties of Liquid Metals. Clarendon Press, 1993, 70-73
- **P. N. QUESTED ; M. MACLEAN.** Solidification Morphologies in Directionally Solidified Superalloys. *Materials Science and Engineering,* 1984, vol. 65, 171-184
- **M. C. SCHNEIDER ; J. P. GU ; C. BECKERMANN ; W. J. BOETTINGER ; U. R. KATTNER.** Modeling of Micro- and Macrosegregation and Freckle Formation in Single-Crystal Nickel-Base Superalloy Directional Solidification. *Metallurgical and Materials Transactions A,* 1997, vol. 28, 1517-1531
- Development of Multicomponent Solidification Micromodels Using a Thermodynamic Phase Diagram Database. **W. J. BOETTINGER ; U. R. KATTNER ; S. R. CORIELL ; Y. A. CHANG ; B. A. MUELLER.** Modeling of Casting, Welding and Advanced Solidification Processes VII. The Minerals, Metals and Materials Society, 1995, 649-656
- **T. M. POLLOCK ; W. H. MURPHY.** The Breakdown of Single-Crystal Solidification in High Refractory Nickel-Base Alloys. *Metallurgical and Materials Transactions A,* 1996, vol. 27, 1081-1094